# EUROPEAN PATENT APPLICATION

(11) **EP 4 343 822 A1**
(43) Date of publication of application: **27.03.2024**
(21) Application number: 23198335.4
(22) Date of filing: 19.09.2023
(51) Int. Cl.: H01L 21/67, H01L 21/677

(54) **SUBSTRATE TREATING APPARATUS**

(30) Priority: 21.09.2022 JP 2022150069
(71) Applicant: SCREEN Holdings Co., Ltd., Kyoto-shi, Kyoto 602-8585 (JP)
(72) Inventor: IZUTA, Takashi, Kyoto-shi, 602-8585 (JP)
(74) Representative: Kilian Kilian & Partner mbB

(57) **Abstract**

Provided is a substrate treating apparatus can be provided that transports substrates reliably and has suppressed manufacturing cost by revising a construction of an apparatus including a batch-type module and a single-wafer-type module.

The present invention especially focuses on a process by a substrate treating apparatus for picking up one substrate from substrates aligned in a vertical posture, turning a posture of the substrate to horizontal, and transporting the substrate to a predetermined position in the vicinity of a single-wafer transport region. With the present invention, a process of picking up the substrate and a process of turning the posture of the substrate are performed independently, achieving simplification in construction of a substrate pick-up unit and reduction in positional error generated when the substrate pick-up unit operates.

## Description

### Cross-Reference to Related Applications

This application claims priority to Japanese Patent Application No. 2022-150069 filed September 21, 2022, the subject matter of which is incorporated herein by reference in entirety.

### Technical Field

The present invention relates to a substrate treating apparatus for performing predetermined treatment on various types of substrates, such as a semiconductor substrate, a substrate for flat panel display (FPD) like liquid crystal display and organic electroluminescence (EL) display, a glass substrate for photomask, and an optical disk substrate.

### Background Art

Such currently-used types of devices include one having a batch-type module and a single-wafer-type module. See, for example, Patent Literature 1. The batch-type module performs predetermined treatment on a plurality of substrates collectively. The single-wafer-type module performs predetermined treatment on substrates one by one. The batch-type module and the single-wafer-type module each have a unique merit. The substrate treating apparatus provided with the batch-type module and the single-wafer-type module possesses the both merits, thereby obtaining a construction having a better advantage than the batch-type substrate treating apparatus or the single-wafer substrate treating apparatus.

The apparatus of the Patent Literature 1 is configured to hold a plurality of substrates, subjected to batch-type treatment, in liquid. The single-wafer treatment is basically performed by treating the substrates one by one. Accordingly, there is need to make the substrates after the batch-type treatment stand-by temporally and to perform single-wafer treatment to the substrates sequentially. Consequently, the currently-used construction adopts a feature to hold the substrates, after the batch-type treatment, temporally at a standby position, and take the held substrates with the transfer arm one by one to transport the substrates to the single-wafer-type module.

### Prior Art Document

### Patent Literature

[Patent Literature 1]
Japanese Unexamined Patent Publication No. 2021-064654

### Summary of Invention

### Technical Problem

The currently-used device having such a configuration has the following problems.

That is, the currently-used construction is complicated in apparatus construction in the vicinity of the transfer arm, resulting in difficulty in control of the apparatus. The transfer arm in the currently-used apparatus performs complicated operation such as picking up the substrates, standby in a vertical posture, in the vertical direction, turning a posture of the taken substrates from vertical to horizontal, and transporting the substrates, whose posture is turned, to the single-wafer-type module. In order to realize such a construction as above, there needs a six-axis robot or a robot that can perform operation with flexibility of a six-axis robot or higher. The robot with high flexibility is hard to control, and is also expensive.

The present invention has been made regarding the state of the art noted above, and its object is to provide a substrate treating apparatus that transports substrates reliably and has suppressed manufacturing cost by revising a construction of an apparatus including a batch-type module and a single-wafer-type module.

### Solution to Problem

To achieve the object, the present invention provides a configuration as follows.

One aspect of the present invention provides a substrate treating apparatus for successively performing batch treatment for processing a plurality of substrates collectively and single-wafer treatment for processing the substrates one by one. The substrate treating apparatus includes: a stocker block, a transferring block adjoining the stocker block, and a treating block adjoining the transferring block, the stocker block including a substrate-taking and accommodating carrier mount shelf which has at least one carrier placed thereon for taking the substrates into and out of the carrier and which is configured to house the carrier in which the substrates are accommodated while the substrates are aligned in a horizontal posture at a predetermined pitch in a vertical direction, the transferring block including a taking handling mechanism configured to take the substrates collectively from the carrier placed on the carrier mount shelf, a posture turning mechanism configured to turn a posture of the taken substrates collectively between a horizontal posture and a vertical posture, and a substrate holder configured to hold the substrates in the vertical posture collectively at a predetermined batch substrate delivery position, the treating block including a batch treatment region whose first end adjoins the transferring block and whose second end extends apart from the transferring block, a single-wafer treatment region spaced apart from the batch treatment region in a direction orthogonal to an extension direction of the batch treatment region, a single-wafer transport region between the batch treatment region and the single-wafer treatment region, and a batch substrate transport region which is provided along the batch treatment region and whose first end extends to the transferring block and whose second end extends apart from the transferring block, the batch treatment region containing a plurality of batch process tanks configured to perform immersion treatment on the substrates collectively in the extension direction of the batch treatment region, and further containing a holding tank configured to hold the substrates, aligned in the vertical posture in a predetermined direction orthogonal to the extension direction, in liquid, a lifter configured to move the substrates upward and downward relative to the holding tank, and a substrate pick-up unit configured to pick up one substrate from the substrates in the vertical posture held by the holding tank and turn a posture of the substrate from vertical to horizontal, the substrate pick-up unit including one-paired rods which are provided above the holding tank and extend along an alignment direction of the substrates in the vertical posture held by the holding tank, a support base configured to support a base of the one-paired rods, a first gripper which moves reciprocatively in the alignment direction of the substrates in the vertical posture while being guided by one of the one-paired rods, a second gripper which moves reciprocatively in the alignment direction of the substrates in the vertical posture while being guided by the other of the one-paired rods, a gripper moving mechanism configured to bring the first gripper and the second gripper into a stand-by state, and move the first gripper and the second gripper under the stand-by state horizontally and move relatively to the lifter in the vertical direction, thereby bringing the first gripper and the second gripper into a substrate-gripped state, the gripper moving mechanism moving the first gripper and the second gripper to a position where the first gripper and the second gripper do not contact the substrate held by the lifter when the first gripper and the second gripper positioned below the substrate held by the lifter move relatively to the lifter in the vertical direction in the stand-by state, the gripper moving mechanism moving the first gripper and the second gripper to a position where the first gripper and the second gripper contact the substrate held by the lifter when the first gripper and the second gripper positioned below the substrate held by the lifter move relatively to the lifter in the vertical direction, and causing the first gripper and the second gripper to hold one substrate of the substrates held by the lifter in the substrate-gripped state, and a rod rotating mechanism configured to turn a posture of the substrate, held by the first gripper and the second gripper, from the vertical posture to the horizontal posture by rotating the one-paired rods to be along the vertical direction while the first gripper and the second gripper holds the one substrate in the vertical posture, the single-wafer treatment region further containing at least one single-wafer processing chamber configured to process the substrates one by one individually, the single-wafer transport region containing a single-wafer substrate transport mechanism configured to transport the substrates, received from the substrate pick-up unit, to the single-wafer processing chamber, the batch substrate transport region containing a batch substrate transport mechanism configured to transport the substrates collectively among the batch substrate delivery position defined in the transferring block, the batch process tank, and the holding tank, and the transferring block further including a returning handling mechanism provided between the single-wafer treatment region in the treating block and the carrier mount shelf in the stocker block and configured to transport the substrates in the horizontal posture from the single-wafer treatment region to the carrier mount shelf.

The aspect of the present invention described in the above (1) can further simplify the construction of the substrate treating apparatus provided with the batch-type module and the single-wafer-type module. The apparatus according to the aspect of the present invention includes the posture turning mechanism configured to turn the horizontal posture of the substrates aligned in the vertical direction collectively to the vertical posture, a plurality of batch process tanks configured to collectively perform liquid treatment to the substrates whose posture is turned, and the holding tank where the substrates after the liquid treatment stand by. This embodiment has the construction in which the different mechanisms realizes complicated operation of taking one substrate at a stand-by state from the holding tank and turning a posture of the substrate. That is, the present apparatus has the construction in which one substrate is taken out from the holding tank by relative movement of the first gripper, the second gripper, and the lifter in the vertical direction and the construction in which a posture of the substrate is turned by the rod rotating mechanism. The relative movement of the first gripper, the second gripper, and the lifter in the vertical direction can be realized by simply moving the lifter upward and downward. The rod rotating mechanism can be realized only with the construction of rotating one-paired rods by 90 degrees. Such an aspect of the present invention simplifies the construction of the substrate pick-up unit and also reduces positional errors in movement of the substrate. Such a configuration achieves the substrate treating apparatus that transports substrates reliably and has suppressed manufacturing cost.

The present invention also possesses the following features.
(2) It is preferred in the aspect of the substrate treating apparatus according to the present invention that the substrate pick-up unit further includes a support base moving mechanism which causes the support base to move reciprocatively in the alignment direction of the substrates in the vertical posture held by the holding tank and which transports the substrates in the horizontal posture held by the first gripper and the second gripper to the single-wafer delivery position defined in the treating block, and that the single-wafer substrate transport mechanism receives the substrates at the single-wafer delivery position.
   With the aspect of the present invention described in the above (2), the substrate pick-up unit can transport the substrates in the horizontal posture in the alignment direction of the substrates in the vertical posture held in the holding tank. In such a manner as described above, the substrate pick-up unit can be configured to receive the substrates, transported in the alignment direction, and to transport the substrates to the single-wafer treatment region. This can more simplify the single-wafer substrate transport mechanism.
(3) It is preferred in the aspect of the substrate treating apparatus according to the present invention that the substrate pick-up unit causes the first gripper and the second gripper to hold one substrate of the substrates held by the lifter by vertical movement of the lifter and downward movement of the lifter above the first gripper and the second gripper in the vertical direction.
   With the aspect of the present invention described in the above (3), the substrate pick-up unit causes the first gripper and the second gripper to hold one substrate of the substrates held by the lifter by vertical movement of the lifter and downward movement of the lifter above the first gripper and the second gripper in the vertical direction. In such a configuration as above, operation of the substrate pick-up unit can be completed with use of the lifter as the existing device even when the substrate pick-up unit does not cause first gripper and the second gripper to move upward and downward. Accordingly, the aspect of the present invention described in the above (3) can provide a substrate treating apparatus having a much simpler device construction.
(4) It is preferred in the aspect of the substrate treating apparatus according to the present invention that the gripper moving mechanism in the substrate pick-up unit brings the first gripper and the second gripper into the stand-by state by separating the first gripper and the second gripper apart from each other, and brings the first gripper and the second gripper into the substrate-gripped state by bringing the first gripper and the second gripper closer to each other.
   With the aspect of the present invention described in the above (4), the gripper moving mechanism in the substrate pick-up unit brings the first gripper and the second gripper into the stand-by state by separating the first gripper and the second gripper apart from each other, and brings the first gripper and the second gripper into the substrate-gripped state by bringing the first gripper and the second gripper closer to each other. In such a configuration as above, the first gripper and the second gripper can be moved minimally, leading to provision of the substrate treating apparatus that does not need the substrate pick-up unit having a massive device construction.
(5) It is preferred in the aspect of the substrate treating apparatus according to the present invention that the taking handling mechanism in the transferring block is constituted by a robot, which also serves as the returning handling mechanism.
   With the aspect of the present invention described in the above (5), the taking handling mechanism is constituted by a robot, which also serves as the returning handling mechanism. If a robot as the taking handling mechanism and a robot as the returning handling mechanism are individually arranged in the transferring block, a space left in the transferring block is reduced accordingly, which decreases flexibility of the device construction. With the aspect of the present invention described in the above (5), a mechanism for a lot in which substrates are aligned at a half-pitch can be provided in the transferring block, for example, achieving provision of a substrate treating apparatus having high flexibility of the device construction.
(6) It is preferred in the aspect of the substrate treating apparatus according to the present invention that the holding tank is provided closer to the transferring block than the batch process tank.
   With the aspect of the present invention described in the above (6), the holding tank is provided closer to the transferring block than the batch process tank. In such a configuration as above, substrate treatment can be completed even if the single-wafer substrate transport mechanism does not move in the extension direction. The configuration of the above (6) can much simplify the construction of the single-wafer substrate transport mechanism.
(7) It is preferred in the aspect of the substrate treating apparatus according to the present invention that the single-substrate processing region in the treating block has a plurality of single-wafer processing chambers arranged in the extension direction, and the single-wafer transportation region in the treating block has a first end adjoining the transferring block and a second end extending in the extension direction.
   With the aspect of the present invention described in the above (7), the single-substrate processing region in the treating has a plurality of single-wafer processing chambers arranged in the extension direction. Accordingly, the apparatus of the above (7) can install a larger number of single-wafer processing chambers, leading to enhanced throughput.
(8) It is preferred in the aspect of the substrate treating apparatus according to the present invention that the batch treatment region in the treating block contains a batch process tank configured to store an acid liquid for performing acid treatment on the substrates, and a batch process tank configured to store deionized water for performing rinse treatment on the substrates, and that the holding tank stores a liquid where isopropyl alcohol is mixed or deionized water.
   With the aspect of the present invention described in the above (8), natural dry of the substrates standing by before being transported to the substrate pick-up unit can reliably be prevented while the acid treatment on the substrates, subjected to the acid treatment, is certainly stopped. That is, with the configuration, the substrates, subjected to the acid treatment, are reliably rinsed with use of deionized water in the batch process tank, and thereafter dry resistance of the substrates is enhanced with use of the holding tank storing the diluted isopropyl alcohol. With the configuration, rinse process and dry-prevention process are performed in different tanks, processing can be performed while keeping deionized water for the rinse process and diluted isopropyl alcohol for the dry-prevention process. The holding tank in this configuration does not emit an organic solvent waste liquid as much as possible, achieving provision of a substrate treating apparatus whose environmental load is decreased.
(9) It is preferred in the aspect of the substrate treating apparatus according to the present invention that the single-wafer processing chamber performs dry treatment with supercritical fluid.
   With the aspect of the present invention described in the above (9), the substrates can be dried with a surface tension of zero, achieving prevention of collapse of the circuit patterns on the substrates, i.e., pattern collapse.
(10) It is preferred in the aspect of the substrate treating apparatus according to the present invention that a plurality of single-wafer processing chambers is provided in the vertical direction in the single-wafer treatment region.
   With the aspect of the present invention described in the above (10), treatment can be performed in parallel with use of the single-wafer processing chambers, achieving provision of the substrate treating apparatus with high throughput.
(11) It is preferred in the aspect of the substrate treating apparatus according to the present invention that the treating block further includes a support portion configured to support the substrates, transported to the single-wafer delivery position, from a side adjacent to the single-wafer transport region.

The aspect of the present invention described in the above (11) can provide a substrate treating apparatus that can transport the substrates reliably without the substrates in the horizontal posture, transported to the single-wafer delivery position, sliding toward the single-wafer transport region.

### Advantageous Effects of Invention

With the aspect of the present invention, a substrate treating apparatus can be provided that transports substrates reliably and has suppressed manufacturing cost by revising a construction of an apparatus including a batch-type module and a single-wafer-type module. The present invention especially focuses on a process by the substrate treating apparatus for picking up one substrate from substrates aligned in the vertical posture, turning a posture of the substrate to horizontal, and transporting the substrate to a predetermined position in the vicinity of the single-wafer transport region. With the present invention, a process of picking up the substrate and a process of turning the posture of the substrate are performed independently, achieving simplification in construction of the substrate pick-up unit and reduction in positional error generated when the substrate pick-up unit operates.

### Brief Description of Drawings

For the purpose of illustrating the invention, there are shown in the drawings several forms which are presently preferred, it being understood, however, that the invention is not limited to the precise arrangement and instrumentalities shown.
Fig. 1 is a plan view illustrating an overall construction of a substrate treating apparatus according to one embodiment.
Fig. 2 is a perspective view illustrating a posture turning mechanism according to the embodiment.
Fig. 3 is a schematic view illustrating substrate transfer according to the embodiment.
Fig. 4 is a perspective view illustrating a construction of a substrate pick-up unit according to the embodiment.
Fig. 5 is a functional block diagram illustrating the construction of the substrate pick-up unit according to the embodiment.
Fig. 6 is a functional block diagram illustrating the construction of the substrate pick-up unit according to the embodiment.
Fig. 7 is a schematic view illustrating the construction of a substrate pick-up unit according to the embodiment.
Fig. 8 is a perspective view illustrating the construction of the stopper according to the embodiment.
Fig. 9 is a plan view illustrating the construction of the stopper according to the embodiment.
Fig. 10 is a plan view illustrating the construction of the stopper according to the embodiment.
Fig. 11 is a sectional view illustrating substrate delivery according to the embodiment.
Fig. 12 is a schematic view illustrating the substrate delivery according to the embodiment.
Fig. 13 is a schematic view illustrating the substrate delivery according to the embodiment.
Fig. 14 is a schematic view illustrating the substrate delivery according to the embodiment.
Fig. 15 is a schematic view illustrating the substrate delivery according to the embodiment.
Fig. 16 is a schematic view illustrating the substrate delivery according to the embodiment.
Fig. 17 is a schematic view illustrating the substrate delivery according to the embodiment.
Fig. 18 is a schematic view illustrating the substrate delivery according to the embodiment.
Fig. 19 is a schematic view illustrating the substrate delivery according to the embodiment.
Fig. 20 is a schematic view illustrating the substrate delivery according to the embodiment.
Fig. 21 is a schematic view illustrating the substrate delivery according to the embodiment.
Fig. 22 is a flowchart illustrating a series of substrate treatment according to the embodiment.
Fig. 23 is a schematic view illustrating the series of substrate treatment according to the embodiment.
Fig. 24 is a schematic view illustrating the series of substrate treatment according to the embodiment.
Fig. 25 is a schematic view illustrating the series of substrate treatment according to the embodiment.
Fig. 26 is a plan view illustrating one modification of the present invention.
Fig. 27 is a plan view illustrating another modification of the present invention.
Fig. 28 is a plan view illustrating another modification of the present invention.

### Description of Embodiments

The following describes one embodiment of the present invention with reference to drawings. A substrate treating apparatus according to one aspect of the present invention successively performs batch treatment for processing a plurality of substrates W collectively and a single-wafer processing for processing the substrates W one by one.

### Embodiment

### <1. Overall Configuration>

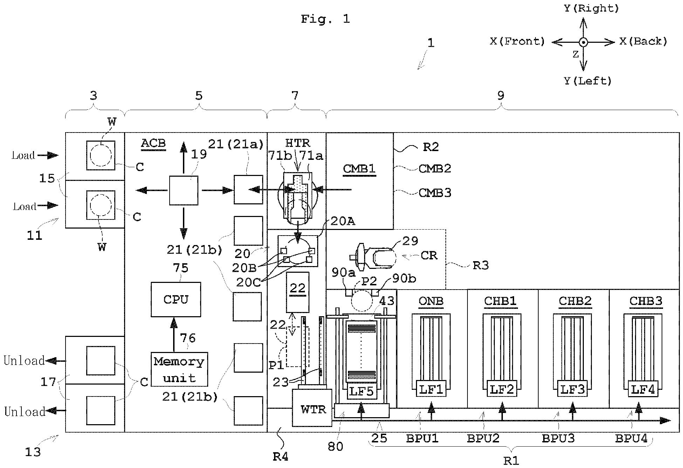

As illustrated in Fig. 1, a substrate treating apparatus 1 includes blocks each defined by partitions. Specifically, the substrate treating apparatus 1 includes a loading and unloading block 3, a stocker block 5 adjacent to the loading and unloading block 3, a transferring block 7 adjacent to the stocker block 5, and a treating block 9 adjacent to the transferring block 7. The stocker block 5 corresponds to the stocker block in the present invention. The transferring block 7 corresponds to the transferring block in the present invention. The treating block 9 corresponds to the treating block in the present invention.

The substrate treating apparatus 1 performs chemical liquid treatment, cleaning treatment, dry treatment, and the like, for example, on the substrates W having a discal shape. The substrate treating apparatus 1 adopts a processing type (so-called a hybrid type) in which both batch-type treatment for processing a plurality of substrates W collectively and single-wafer treatment for processing the substrates W one by one are used together. In the batch-type processing, the substrates W aligned in a vertical posture are processed collectively. In the single-wafer processing, the substrates W in a horizontal posture are processed one by one.

In the present specification, the direction in which the loading and unloading block 3, the stocker block 5, the transferring block 7, and the treating block 9 are arranged is referred to as a "front-back direction (X-direction)" for convenience. The front-back direction (X-direction) is horizontal. One direction of the front-back direction (X-direction) from the stocker block 5 to the loading and unloading block 3 is referred to as "forward", whereas a direction opposite to the forward is referred to as "rearward". A horizontal direction orthogonal to the front-back direction (X-direction) is referred to as a "transverse direction (Y-direction)". One of a transverse direction is referred to "rightward", whereas the other is referred to as "leftward" for convenience. A height direction orthogonal to the front-back direction (X-direction) and the transverse direction (Y-direction) is referred to as a "vertical direction (Z-direction)" for convenience. For reference, the drawings show front, rear, right, left, up, and down, as appropriate.

### <2. Loading and unloading block>

The loading and unloading block 3 includes a loading unit 11 as an inlet used when a carrier C, accommodating the substrates W in a horizontal posture by a given interval in the vertical direction, is loaded in the block, and an unloading unit 13 as an outlet used when the carrier C is unloaded out of the block. The loading unit 11 and the unloading unit 13 are provided on an outer wall of the loading and unloading block 3 extending in the transverse direction (Y-direction). The loading unit 11 is arranged rightward from a center portion in the transverse direction (Y-direction) of the substrate treating apparatus 1. The unloading unit 13 is arranged leftward from the center portion in the transverse direction (Y-direction) of the substrate treating apparatus 1, i.e., opposite to rightward.

A plurality of (e.g., twenty-five) substrates W are accommodated within one carrier C in a stack manner at uniform pitches in a horizontal posture. The carrier C accommodating untreated substrates W to be transported to the substrate treating apparatus 1 is firstly placed on the loading unit 11. The loading unit 11 includes two mount tables 15, for example, on which the carrier C is placed. The carrier C has a plurality of grooves (not shown) formed therein extending horizontally for housing the substrates W while faces of the substrates W are separated apart from one another. The substrates W are inserted into the grooves one by one. Examples of the carrier C include a sealed-type front opening unify pod (FOUP). Alternatively, an opened-type container may be adopted as the carrier C in the present invention.

The unloading unit 13 unloads the carrier C containing the processed substrates W loaded from the substrate treating apparatus 1. Similar to the loading unit 11, the unloading unit 13 functioning as above includes two mount tables 17, for example, on which the carrier C is placed. The loading unit 11 and the unloading unit 13 are also referred to as a load port.

### <3. Stocker block>

The stocker block 5 adjoints the rearward of the loading and unloading block 3. The stocker block 5 includes a transporting and accommodating unit ACB for storing and keeping the carrier C. The transporting and accommodating unit ACB includes a carrier transport mechanism 19 for transporting the carrier C, and a shelf 21 for placing the carrier C thereon. The stocker block 5 can contain one or more numbers of carriers C.

The shelf 21 of the stocker block 5 is used for placing the carrier C thereon. The shelf 21 is provided on the partition separating the stocker block 5 from the transferring block 7. The shelf 21 is classified by a storage shelf 21b for simply placing the carrier C temporarily, and a carrier mount shelf 21a accessible by a first transport mechanism HTR in the transferring block 7 for receiving and delivering the substrates W. The carrier mount shelf 21a corresponds to the carrier mount shelf for taking and accommodating the substrates W in the present invention. The carrier C is placed on the carrier mount shelf for loading and unloading the substrates W therefrom. A carrier C from which the substrates are unloaded is placed on the carrier mount shelf 21a. After the substrates W are unloaded, the carrier C on the carrier mount shelf 21a is empty. The unloaded substrates W are subject to various types of processing in the treating block 9. The processed substrates W are returned to the original carrier C on the carrier mount shelf 21a one by one. In this embodiment, one carrier mount shelf 21a is provided. Instead of this, a plurality of carrier mount shelves 21a may be provided.

The carrier transport mechanism 19 takes the carrier C, in which untreated substrates W are housed, from the loading unit 11, and places the carrier C on the carrier mount shelf 21a. At this time, the carrier transport mechanism 19 may place the carrier C on the storage shelf 21b temporarily before placing the carrier C on the carrier mount shelf 21a. Moreover, the carrier transport mechanism 19 receives the carrier C where the treated substrates W are accommodated from the carrier mount shelf 21a, and places the carrier C on the unloading unit 13. At this time, the carrier transport mechanism 19 may place the carrier C on the storage shelf 21b temporarily before placing the carrier C on unloading unit 13.

### <4. Transferring block>

The transferring block 7 adjoints rearward of the stocker block 5. The transferring block 7 includes the first transport mechanism HTR that is accessible to the carrier C on the carrier mount shelf 21a on which the carrier C where the substrates W are taken out is placed, a posture turning unit 20 for turning a posture of the substrates W collectively from horizontal to vertical, and a pusher mechanism 22 configured to receive the substrates W in a vertical posture collectively from the posture turning unit 20 and capable of holding the substrates W in a batch substrate delivery position P1. The first transport mechanism HTR corresponds to the taking handling mechanism in the present invention. The posture turning unit 20 corresponds to the posture turning mechanism in the present invention. The pusher mechanism 22 corresponds to the substrate holder in the present invention. Moreover, the batch substrate delivery position P1 is set in the transferring block 7 for delivering the substrates W to a second transport mechanism WTR provided in a batch substrate transport region R4. The first transport mechanism HTR, the posture turning unit 20, and the pusher mechanism 22 are arranged in this order in a right-left direction (Y-direction). The batch substrate delivery position P1 is set laterally of the pusher mechanism 22 and opposite to the posture turning unit 20.

The first transport mechanism HTR is provided rearward and rightward of the transporting and accommodating unit ACB in the stocker block 5. The first transport mechanism HTR is a mechanism used for taking out twenty-five substrates W, for example, collectively from the carrier C placed on the carrier mount shelf 21a for substrate taking and returning, and for returning the processed substrates W one by one to the carrier C. The first transport mechanism HTR includes twenty-five taking hands 71a, for example, that take unprocessed substrates W collectively. One of the taking hands 71a is constituted by one-paired arms that can support one substrate W. Twenty-five taking hands 71a are used when taking the twenty-five substrates W from the carrier C. In addition to the taking hands 71a, the first transport mechanism HTR includes a returning hand 71b used when the processed substrates W are returned to the carrier C. The returning hand 71b is constituted by one-paired arms. In this embodiment, one returning hand 71b is provided in the first transport mechanism HTR. Instead of this, a plurality of returning hands 71b may be provided. Such a construction is advantageous when the processed substrates W are collectively transported from single-wafer processing chambers CMB individually. The taking hand 71a and the returning hand 71b overlap with each other when seen from the vertical direction (Z-direction). In this regard, an uppermost taking hand 71a in Fig. 1 is representative of the hands. The returning hand 71b is provided below the twenty-five taking hands 71a, and thus a lowermost hand. Provision of the taking hands 71a and the returning hand 71b achieves easy control of the first transport mechanism HTR.

The first transport mechanism HTR can transport the twenty-five substrates W, held by the taking hands 71a, to a support base 20A of the posture turning unit 20. The posture turning unit 20 receives and turns the substrates W in the horizontal posture to the vertical posture. The pusher mechanism 22 can receive the substrates W in the vertical posture from the posture turning unit 20, and can move the substrates W vertically and horizontally.

Moreover, the first transport mechanism HTR receives the processed substrates W in the horizontal posture one by one from the treating block 9, mentioned later, with use of the returning hand 71b. Then, the first transport mechanism HTR returns the substrates W, received while a posture of the substrates W is kept, to the empty carrier C on the carrier mount shelf 21a. The returning hand 71b can advance and retract in a direction where the arms constituting the returning hand 71b extend. That is, the returning hand 71b can be brought from an alignment state where it overlaps the taking hands 71a in the vertical direction (Z-direction) into a protrusion state where it advances and protrudes relative to the taking hands 71a, and vice versa. Here, a state of the returning hand 71b when the first transport mechanism HTR transports the substrates W with use of the taking hands 71a is the alignment state, which does not cause interference in the transportation with use of the taking hands 71a. Moreover, a state of the returning hand 71b when the first transport mechanism HTR transports one substrate W with use of the returning hand 71b is the protrusion state, which does not cause the taking hands 71a to interfere in the transportation with use of the returning hand 71b. In the first transport mechanism HTR in this embodiment, the returning hand 71b is provided below the taking hand 71a. In contrast to this, the returning hand 71b may be provided above the taking hand 71a. The first transport mechanism HTR corresponds to the returning handling mechanism in the present invention. The first transport mechanism HTR is a mechanism provided between a single-wafer treatment region R2 in the treating block 9 and the carrier mount shelf 21a in the stocker block 5, and transports the substrates W in the horizontal posture from the single-wafer treatment region R2 to the carrier mount shelf 21a. The taking hands 71a correspond to the taking handling mechanism in the present invention, and the returning hand 71b corresponds to the returning handling mechanism in the present invention. The taking handling mechanism in the transferring block 7 is constituted by a robot, which also serves as the returning handling mechanism.

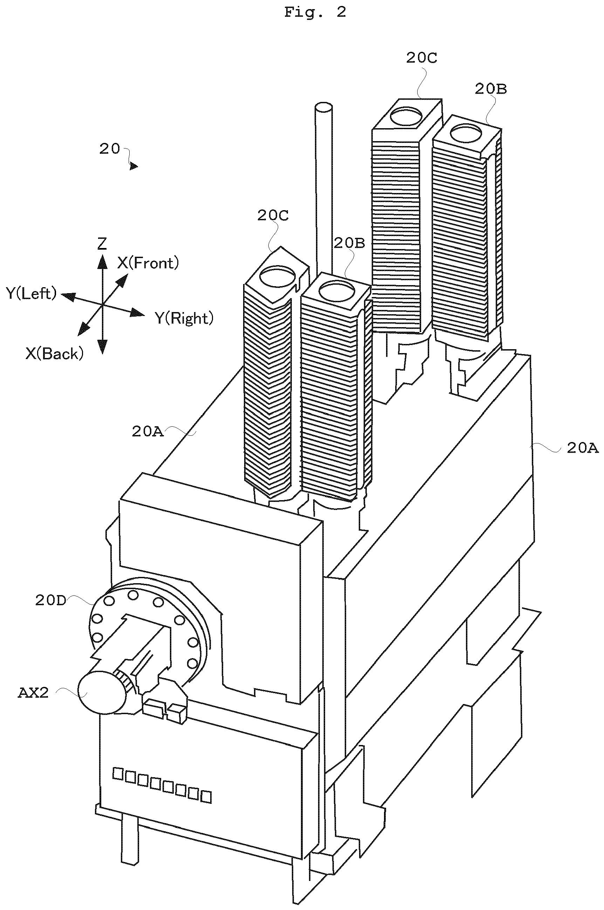

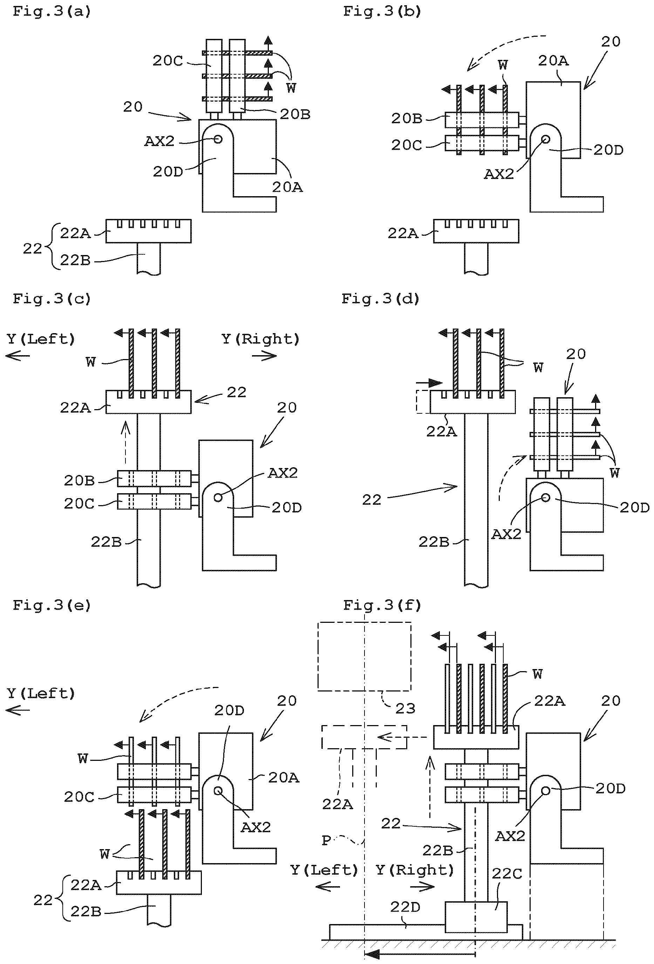

Fig. 2 is an explanation view of the posture turning unit 20 in this embodiment. The posture turning unit 20 includes one-paired horizontal holders 20B and one-paired vertical holders 20C both extending in the vertical direction (Z-direction). The support base 20A has a support face in an X-Y plane for supporting the horizontal holders 20B and the vertical holders 20C. A rotation driving mechanism 20D is configured to rotate the horizontal holders 20B and the vertical holders 20C by 90 degrees together with the support base 20A. Such rotation causes the horizontal holders 20B and the vertical holders 20C to extend in the right-left direction (Y-direction). Here, Fig. 3 is a schematic view illustrating operation of the posture turning unit 20. Description is made hereunder to each component with reference to Figs. 2 and 3.

The horizontal holder 20B holds the substrates W in the horizontal posture individually from a lower face side of the substrates W. That is, the horizontal holder 20B is formed in a comb shape having a plurality of protrusions in correspondence to the substrates W to be supported. Between two adjacent protrusions, formed is an elongated recess where a peripheral edge of the substrate W lies. When the peripheral edge of the substrate W is inserted in the recess, a lower face of the substrate W in the horizontal posture contacts an upper face of the protrusion, whereby the substrate W is supported in the horizontal posture.

The vertical holder 20C holds the substrates W in the vertical posture individually from the lower face side of the substrates W. That is, the vertical holder 20C is formed in a comb shape having a plurality of protrusions in correspondence to the substrates W to be supported. Between two adjacent protrusions, formed is an elongated V-shaped groove where a peripheral edge of the substrate W lies. When the peripheral edge of the substrate W is inserted in the V-shaped groove, the substrate W is gripped and supported with the V-shaped groove in the vertical posture. Since two vertical holders 20C are provided on the support base 20A, two positions on the peripheral edge of the substrate W are gripped with different V-shaped grooves.

The one-paired horizontal holders 20B and the one-paired vertical holders 20C extending in the vertical direction (Z-direction) are provided along an imaginary circle surrounding a substrate W to be held and corresponding to the substrates W in the horizontal posture. The one-paired horizontal holders 20B are spaced apart from each other by a diameter of the substrate W, and hold a first end of the substrate W and a second end as a position located furthest from the first end. In such a manner as above, the one-paired horizontal holders 20B support the substrate W in the horizontal posture. In contrast to this, the one-paired vertical holders 20C are spaced apart from each other by a distance smaller than the diameter of the substrate W, and support a given portion of the substrate W and a specified portion in the vicinity of the given portion. In such a manner as above, the one-paired vertical holders 20C support the substrate W in the vertical posture. The one-paired horizontal holders 20B are located at the same position in the right-left direction (Y-direction). The one-paired vertical holders 20C are located at the same position in the right-left direction (Y-direction). The one-paired vertical holders 20C are provided on a left side, closer than the one-paired horizontal holders 20B, where the support base 20A rotates and falls down.

The rotation driving mechanism 20D supports the support base 20A so as to rotate the support base 20A by at least 90 degrees around a horizontal axis AX2 extending in the front-back direction (X-direction). When the support base 20Ain a horizontal state is rotated by 90 degrees, the support base 20A turns to a vertical state, whereby a posture of the substrates W held by the horizontal holders 20B and the vertical holders 20C is turned from horizontal to vertical.

As shown in Fig. 3(f), the pusher mechanism 22 includes a pusher 22A on which the substrates W in the vertical posture can be placed, a lifting and rotating portion 22B for rotating and lifting the pusher 22A, a horizontally moving portion 22C for moving the pusher 22A in the right-left direction (Y-direction), and a rail 22D extending in the right-left direction (Y-direction) for guiding the horizontally moving portion 22C. The pusher 22A supports each lower part of plurality of (e.g., fifty) substrates W in the vertical posture. The lifting and rotating portion 22B is provided below the pusher 22A, and includes a mechanism that can expand and contract, thereby moving the pusher 22A in the up-down direction. Moreover, the lifting and rotating portion 22B can rotate the pusher 22A by at least 180 degrees around a vertical axis. The horizontally moving portion 22C supports the lifting and rotating portion 22B, and moves the pusher 22A and the lifting and rotating portion 22B horizontally. The horizontally moving portion 22C is guided along the rail 22D, and can move the pusher 22A from a pick-up position near the posture turning unit 20 to the batch substrate delivery position P1. Moreover, the horizontally moving portion 22C can shift the substrates W in the vertical posture in an alignment direction of the substrates W by a distance corresponding to a half pitch at which the substrates W are aligned.

Description is now made of operation of the posture turning unit 20 and the pusher mechanism 22. With the posture turning unit 20 and the pusher mechanism 22, fifty substrates W in total that are accommodated in two carriers C, for example, are aligned at a predetermined pitch (e.g., 5 mm) in a face-to-back system. Twenty-five substrates W in a first carrier C are to be described as first substrates W1 in a first substrate group. Likewise, twenty-five substrates W in a second carrier C are to be described as second substrates W2 in a second substrate group. It should be noted that, in Figs. 3(a) to 3(f), the number of first substrates W1 is three, and the number of second substrates W2 is three for convenience of drawing.

Fig. 3(a) shows a state where the first transport mechanism HTR delivers the first substrates W1 in the horizontal posture to the posture turning unit 20 collectively. At this time, a device face (circuit pattern formation face) of each of the first substrates W1 is directed upward. The twenty-five first substrates W1 are arranged at a predetermined pitch (e.g., 10 mm). The pitch of 10 mm is called a full pitch (normal pitch). The first substrates W1 under such a state are held by the horizontal holder 20B. Here, the pusher 22A at this time is located at the pick-up position lower than the support base 20A.

Fig. 3(b) shows a state where the rotation driving mechanism 20D rotates the support base 20A of the posture turning unit 20 by 90 degrees. Accordingly, the posture turning unit 20 turns a posture of the twenty-five first substrates W1 from horizontal to vertical. The first substrates W1 under such a state are held by the vertical holder 20C.

Fig. 3(c) shows a state where the pusher 22A is moved upward from the pick-up position to a directly above position that is set higher than the pick-up position. Such upward movement is performed by the lifting and rotating portion 22B. In such a manner as above, when the pusher 22A is moved upward from the below of the first substrates W1, the first substrates W1 supported by the vertical holder 20C of the posture turning unit 20 are pulled out of the vertical holder 20C and are moved onto the pusher 22A. Grooves are formed in an upper face of the pusher 22A for inserting substrates W. The first substrates W1 are supported by these grooves arranged at equal intervals. The grooves are arranged at a half pitch, i.e., half a full pitch, and the first substrates W1 are aligned in the posture turning unit 20 at a full pitch. Accordingly, grooves where the first substrates W1 are inserted individually and free grooves where the substrates W are not supported are arranged alternately on the upper face of the pusher 22A at the directly above position.

Fig. 3(d) shows operation where the pusher 22A is moved by a half-pitch width and operation where the support base 20A of the posture turning unit 20 is rotated reversely by 90 degrees by the rotation driving mechanism 20D. The posture turning unit 20 in this state can support the second substrates W2. Fig. 3(d) shows a state condition where the second substrates W2 are already transported in the posture turning unit 20. Here in Fig. 3(d), the second substrates W2 are supported by the horizontal holder 20B.

When the pusher 22A at the directly above position in Fig. 3(d) returns to its original pick-up position, the posture turning unit 20 can rotate the support base 20A again by 90 degrees.

Fig. 3(e) shows a state where the support base 20A is rotated again. At this time, the pusher 22A is moved by the half-pitch width. Accordingly, when the pusher 22A is moved to the directly above position as shown in Fig. 3(f), the second substrates W2 are inserted into free grooves, formed between the first substrates W1, on the upper face of the pusher 22A without interference of the first substrates W1. In this way, a lot is formed where the first substrate W1 and the second substrate W2 are alternately aligned. Here in Fig. 3(e), the second substrates W2 are supported by the vertical holder 20C. The lot is formed by arranging the substrates W in the face-to-back system, and thus device faces of the substrates W that form the lot are all directed leftward in Fig. 3(f). As descried above, fifty substrates W are aligned on the pusher 22A at a half pitch in the face-to-back system.

Fig. 3(f) shows a state where the pusher 22A is moved again to the directly above position. Then, the horizontally moving portion 22C transports and moves the lot, formed at the pusher 22A, leftward (Y-direction) to the batch substrate delivery position P1.

As described above, the pusher mechanism 22 corresponds to the substrate holder that holds the substrates in the vertical posture collectively at the predetermined batch substrate delivery position P1 in the present invention. Here in this embodiment, a mechanism for rotating the pusher 22A by 180 degrees around an axis parallel to the vertical direction (Z-direction) may be added to the pusher mechanism 22.

### <5. Treating block>

The treating block 9 performs various types of treatment on the substrates W. The treating block 9 is divided into a batch treatment region R1, the single-wafer treatment region R2, a single-wafer transport region R3, and the batch substrate transport region R4 that are arranged in the transverse direction (Y-direction). The batch treatment region R1 and the batch substrate transport region R4 extend in the front-back direction (X-direction). The single-wafer treatment region R2 and the single-wafer transport region R3 are provided in a front part of the treating block 9 so as to be adjacent to the transferring block 7. Specifically, the batch treatment region R1 is provided in a left part of the treating block 9. The single-wafer treatment region R2 is provided in a right part of the treating block 9. The single-wafer transport region R3 is arranged between the batch treatment region R1 and the single-wafer treatment region R2, i.e., a center portion of the treating block 9. The batch substrate transport region R4 is arranged in a leftmost part of the treating block 9.

### <5-1. Batch treatment region>

The batch treatment region R1 in the treating block 9 is a rectangular region extending in the front-back direction (X-direction). A first end side (front end side) of the batch treatment region R1 adjoins the transferring block 7. A second end side of the batch treatment region R1 extends in a direction apart from the transferring block 7 (rearward).

The batch treatment region R1 includes a batch-type processing unit for mainly performing batch-type treatment. Specifically, the batch treatment region R1 has a plurality of batch processing units BPU1 to BPU4, arranged in a direction where the batch treatment region R1 extends, where the substrates W are collectively immersed. The batch treatment region R1 also includes an in-liquid holding unit 25 for holding the substrates W in the vertical posture in liquid.

The following describes arrangement of the batch processing units BPU1 to BPU4 in detail. A first batch processing unit BPU1 adjoins rearward of the in-liquid holding unit 25. A second batch processing unit BPU2 adjoins rearward of the first batch processing unit BPU1. A third batch processing unit BPU3 adjoins rearward of the second batch processing unit BPU2. A fourth batch processing unit BPU4 adjoins rearward of the third batch processing unit BPU3. Accordingly, the first batch processing unit BPU1, the second batch processing unit BPU2, the third batch processing unit BPU3, and the fourth batch processing unit BPU4 are apart from the transferring block 7 in this order. As described above, the in-liquid holding unit 25, the first batch processing unit BPU1, the second batch processing unit BPU2, the third batch processing unit BPU3, and the fourth batch processing unit BPU4 are arranged in this order in a direction where the batch treatment region R1 extends (front-batch processing unit: X-direction).

Specifically, the first batch processing unit BPU1 includes a batch rinse process tank ONB where rinse treatment is performed to the lot collectively, and a lifter LF1 for moving the lot upward and downward. The batch rinse process tank ONB performs the rinse treatment to the lot. The batch rinse process tank ONB contains deionized water, and is provided for cleaning chemical adhered to the substrates W. When a specific resistance of the deionized water in the batch rinse process tank ONB increases to a predetermined value, cleaning treatment is completed.

The second batch processing unit BPU2 is a part where the substrates W are transported before reaching the first batch processing unit BPU1, and specifically includes a batch chemical process tank CHB1 and a lifter LF2 for moving the lot upward and downward. The batch chemical process tank CHB1 contains a chemical like a phosphoric acid solution. The batch chemical process tank CHB1 has the lifter LF2 attached thereto for moving the lot upward and downward. The batch chemical process tank CHB1 supplies the chemical upward from the below, for example, to swirl the chemical. The lifter LF2 moves in the vertical direction (Z-direction). Specifically, the lifter LF2 moves upward and downward between a processing position inside of the batch chemical process tank CHB1 and a delivery position above the batch chemical process tank CHB1. The lifter LF2 holds the lot constituted by the substrates W in the vertical posture. The lifter LF2 delivers the lot at the delivery position to and from the second transport mechanism WTR. When the lifter LF2 moves downward from the delivery position to the processing position while holding the lot, the substrates W are entirely positioned below a liquid level of the chemical. When the lifter LF2 moves upward from the processing position to the delivery position while holding the lot, the substrates W are entirely positioned above the liquid level of the chemical. Specifically, the chemical processing is acid treatment. Here, phosphoric acid treatment may be used for the acid treatment, but treatment with other acid may be adopted. In the phosphoric acid treatment, etching treatment is performed on the substrates W constituting the lot. In the etching treatment, a nitride film on a front face of the substrate W is chemically ground, for example. The substrates W on which the batch chemical processing is performed are subjected to the rinse treatment by the batch rinse process tank ONB in the first batch processing unit BPU1 described above.

Specifically, the third batch processing unit BPU3 includes a batch chemical process tank CHB2 and a lifter LF3 for moving the lot upward and downward. The batch chemical process tank CHB2 has the same configuration as that of the batch chemical process tank CHB1 described above. That is, the batch chemical process tank CHB2 contains the chemical described above, and has the lifter LF3 attached thereto. The batch chemical process tank CHB2 performs the treatment, similar to that performed by the chemical processing unit CHB1, to the lot. The substrate treating apparatus 1 in this embodiment includes a plurality of process tanks where the same chemical processing is performable. This is because the phosphoric acid treatment needs more time than the other treatment. For example, it takes long time (e.g., sixty minutes) to perform the phosphoric acid treatment. Then, the apparatus in this embodiment is configured to perform the acid treatment in parallel in the batch chemical process tanks. Accordingly, the acid treatment is performed on the lot in either the batch chemical process tank CHB1 or CHB2. Such configuration enhances throughput of the apparatus. Specifically, the fourth batch processing unit BPU4 includes a batch chemical process tank CHB3 and a lifter LF4 for moving the lot upward and downward. The batch chemical process tank CHB3 has the same configuration as that of the batch chemical process tank CHB1 described above.

As described above, the batch chemical process tank CHB1, the batch chemical process tank CHB2, and the batch chemical process tank CHB3 in this embodiment are apart further from the transferring block 7 than the batch rinse process tank ONB. That is, the batch chemical process tank CHB1 in this embodiment is located apart from the transferring block 7 by a width of the batch rinse process tank ONB. Such a configuration can prevent corrosion of mechanisms in the transferring block 7 due to an acid solution contained in the batch chemical process tank CHB1. A similar effect is produced in a center robot CR and a substrate pick-up unit 80, which are to be mentioned later. The batch chemical process tank CHB and the batch rinse process tank corresponds to the batch process tank in the present invention.

The in-liquid holding unit 25 adjoins rearward of the transferring block 7. The in-liquid holding unit 25 includes a holding tank 43 in which the lot is immersed in the liquid and a lifter LF5 for moving the lot upward and downward. The holding tank 43 contains isopropyl alcohol (IPA) diluted with deionized water, for example, for preventing drying of the substrates W within the tank. The lifter LF5 receives the lot from the second transport mechanism WTR at the delivery position above the holding tank 43, and moves the substrates W downward to an immersion position (corresponding to the processing position in the batch chemical process tank CHB1), whereby the substrates W are entirely immersed in the deionized water. The holding tank 43 holds the substrates W in the vertical posture in liquid at a position nearest to the transferring block 7 in the batch treatment region R1.

In the in-liquid holding unit 25, the substrate pick-up unit 80 is provided that picks up one substrate W from the substrates W in the vertical posture in the liquid of the holding tank 43 and turns a posture of the substrate W from vertical to horizontal. The substrate pick-up unit 80 transports the substrate W, whose posture is turned horizontal, to a single-wafer delivery position P2 where the substrate W is delivered to the center robot CR in the single-wafer transport region R3 mentioned later.

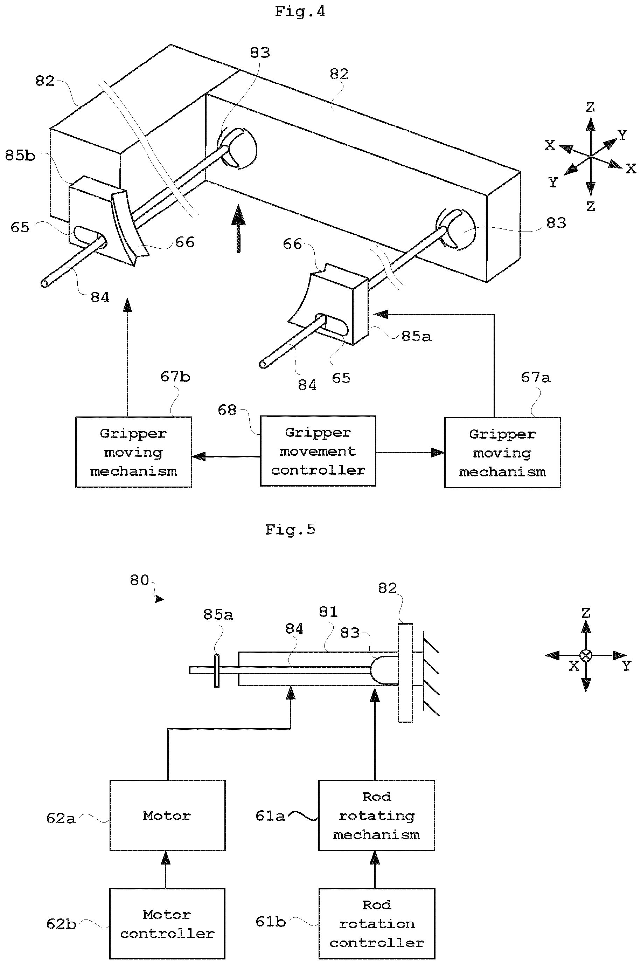

Fig. 4 is a perspective view illustrating the substrate pick-up unit 80 according to this embodiment. As shown in Fig. 4, the substrate pick-up unit 80 includes a support board 82 provided with a main face expanding on a ZX-plane. The support board 82 in this embodiment is supported so as to be movable in the Y-direction with a linear guide 81 mentioned later. One-paired joints 83 are provided on a first end (front side) and a second end (rear side) in the front-back direction (X-direction) of the support board 82. Rods 84 extending in the transverse direction (Y-direction: alignment direction of the substrates W in the vertical posture held in the holding tank 43) are individually provided on the joints 83. Accordingly, the rod 84 is supported on the support board 82 via the joint 83. The rod 84 can rotate around a rotation axis passing through the joint 83 in the front-back direction (X-direction). Especially, the rod 84 can stop at an attitude extending in the transverse direction (Y-direction) and at an attitude extending vertically downward. Here, the transverse direction (Y-direction) corresponds to the predetermined direction in the present invention. The joint 83 corresponds to the rod rotating mechanism in the present invention.

Fig. 5 is a side view illustrating the substrate pick-up unit 80 in the front-back direction (X-direction) according to this embodiment. The joints 83 are each provided with a rod rotating mechanism 61a for rotating the rod 84. The rod rotating mechanism 61a is controlled by a rod rotation controller 61b. The rod rotation controller 61b controls the rod rotating mechanism 61a such that the one-paired rods 84 extending in the transverse direction (Y-direction) rotate while keeping their positional relationship with each other. Accordingly, the one-paired rods 84 parallel to each other in Fig. 4 rotate while keeping their parallel state, thereby being in a posture along the vertical direction (Z-direction).

One of the one-paired rods 84 is provided with a first gripper 85a and the other of the one-paired rods 84 is provided with a second gripper 85b. The first gripper 85a is a plate-shaped member having a long hole 65 formed therein through which the rod 84 passes. One side of the first gripper 85a where the substrate W contacts is curved along a shape of the substrate W. The first gripper 85a is set on the rod 84 such that a curved side thereof is directed rearward.

The following describes a feature of the first gripper 85a that is movable in an extension direction of the rod 84. The first gripper 85a is not secured to the rod 84, and is guided along the rod 84 to be movable in the extension direction of the rod 84. That is, the first gripper 85a is movable from a state in Fig. 4 not only to a proximal end side of the rod 84 but also to a distal end side of the rod 84. At this time, the first gripper 85a is moved to the extension direction of the rod 84 (transverse direction: Y-direction in Fig. 4) while the curved side thereof is kept at a posture directed rearward.

The second gripper 85b has a construction similar to that of the first gripper 85a. Specifically, the second gripper 85b has a plate shape, has a long hole 65 through which the rod 84 passes, has one curved side where the substrate W contacts, and is guided along the rod 84 to be movable in the extension direction of the rod 84, which features are same as those of the first gripper 85a. In contrast to this, the second gripper 85b differs from the first gripper 85a in a feature that the curved side thereof is directed forward. The second gripper 85b is moved to the extension direction of the rod 84 (transverse direction: Y-direction in Fig. 4) while the curved side thereof is kept at a posture directed forward. The second gripper 85b having a plate shape moves along with the first gripper 85a so as to be positioned on the same plane as that where the first gripper 85a having a similar plate shape exists.

The following describes a mechanism and a controller for moving the first gripper 85a and the second gripper 85b in the extension direction of the rod 84. The first gripper 85a includes a gripper moving mechanism 67a for moving the first gripper 85a along the rod 84. Moreover, the second gripper 85b includes a gripper moving mechanism 67b for moving the second gripper 85b along the rod 84. A gripper movement controller 68 is provided for controlling the gripper moving mechanism 67a and the gripper moving mechanism 67b. The gripper movement controller 68 controls the gripper moving mechanism 67a and the gripper moving mechanism 67b such that the first gripper 85a and the second gripper 85b are moved while positional relationship therebetween is kept. Accordingly, the first gripper 85a and the second gripper 85b overlapping each other in the Y-direction in Fig. 4 are guided along the rod 84 and are moved linearly while such an overlapping state is kept.

The curved sides of the first gripper 85a and the second gripper 85b partially conform with an imaginary circle corresponding to a shape of a substrate W to be gripped. The sides are provided with V-shaped grooves 66 individually for engaging the substrate W. Accordingly, when the substrate W to be gripped us held by the first gripper 85a and the second gripper 85b, a peripheral edge of the substrate W is housed in the V-shaped grooves 66. Such a construction allows the V-shaped grooves 66 to fix both faces of the substrate W to be gripped, achieving more rigid grip of the substrate W by the first gripper 85a and the second gripper 85b.

Here, a clearance between the first gripper 85a and the second gripper 85b in a substrate-gripped state mentioned later is smaller than a diameter of the substrate W to be gripped. Such a configuration causes the substrate W, gripped by the first gripper 85a and the second gripper 85b, to be easily pulled out in a direction orthogonal to a direction from the first gripper 85a to the second gripper 85b (i.e., an arrow direction in Fig. 4). That is, the first gripper 85a and the second gripper 85b have a suitable shape for delivering the substrate W to the center robot CR in the single-wafer transport region R3 mentioned later.

The linear guide 81 has a quadrangular prism shape extending in the Y-direction, and support the supports board 82 movably. The linear guide 81 constitutes an electric actuator, The electric actuator has a slider where the support board 82 is provided. Accordingly, the support board 82 can move linearly in an extension direction of the linear guide 81. As shown in Fig. 5, a motor 62a causes the support board 82 to move. A motor controller 62b is configured to control the motor 62a. The linear guide 81 and the motor 62a correspond to the support base moving mechanism in the present invention.

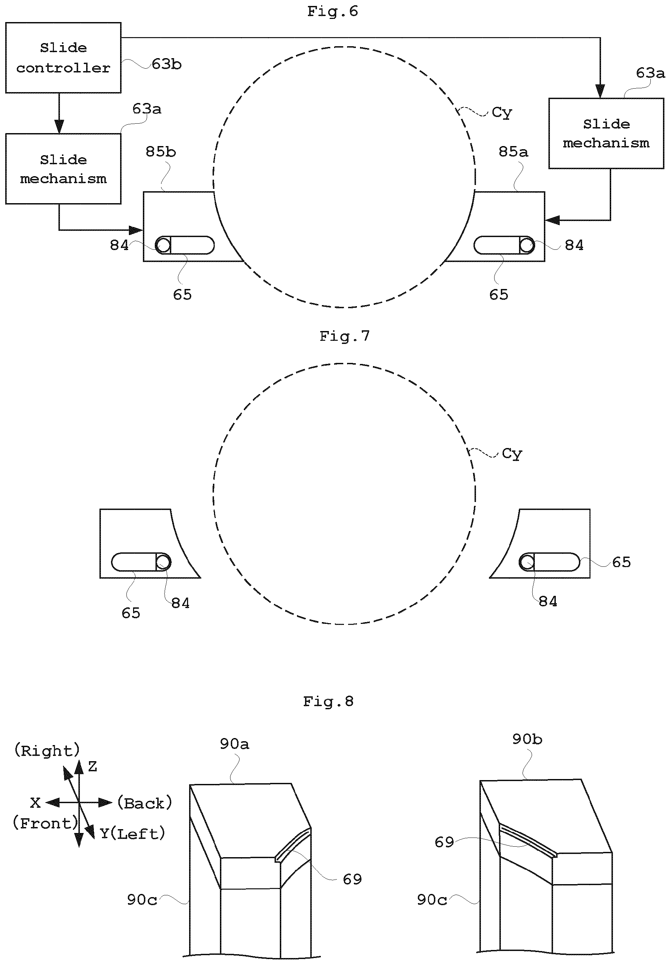

The following describes a feature that the first gripper 85a and the second gripper 85b can approach to and separate from each other. Fig. 6 illustrates a condition, similar to Fig. 4, where the first gripper 85a approaches to the second gripper 85b most closely. At this time, the rod 84 is located at one end of the long hole 65 in the first gripper 85a. Fig. 7 illustrates a condition where the first gripper 85a separates from the second gripper 85b furthest. The rod 84 is located at the other end side of the long hole 65 in the first gripper 85a. A positional relationship of the rod 84 in the second gripper 85b is similar to that in the first gripper 85a. That is, when the first gripper 85a and the second gripper 85b separate from each other, the rod 84 moves from the one end side to the other end side of the long hole 65 in the second gripper 85b.

Fig. 6 illustrates a substrate-gripped state where the first gripper 85a and the second gripper 85b can hold the substrate W. At this time, the curved sides of the first gripper 85a and the second gripper 85b partially conform with an imaginary circle corresponding to a shape of a substrate W to be gripped. Fig. 7 illustrates a stand-by state where the first gripper 85a and the second gripper 85b cannot hold the substrate W. At this time, the curved sides of the first gripper 85a and the second gripper 85b are located apart from the imaginary circle corresponding to a shape of a substrate W to be gripped. Here, a clearance between the first gripper 85a and the second gripper 85b in Fig. 7 is equal to or larger than the diameter of the substrate W to be gripped. Accordingly, under the state in Fig. 7, the substrate W can pass between the first gripper 85a and the second gripper 85b.

The first gripper 85a and the second gripper 85b are provided with slide mechanisms 63a individually for sliding the first gripper 85a in the front-back direction (X-direction) relative to the rod 84, i.e., an extension direction of the long hole 65. A slide controller 63b is configured to control the slide mechanisms 63a. The slide controller 63b controls the slide mechanisms 63a so as to slide the first gripper 85a and the second gripper 85b synchronously. Accordingly, when the first gripper 85a slides, the second gripper 85b slides in a reverse direction to the first gripper 85a by a moving distance of the first gripper 85a. Consequently, the first gripper 85a and the second gripper 85b cooperate to approach to and separate from an imaginary circle Cy. The slide mechanism 63a corresponds to the gripper moving mechanism in the present invention.

The treating block 9 also includes a stopper 90a and a stopper 90b both having a substantially rectangular shape as shown in Fig. 8 for helping hold of the substrate W by the first gripper 85a and the second gripper 85b. As shown in Fig. 1, the stopper 90a and the stopper 90b each have a curved side that forms a circumference of the imaginary circle, corresponding to the substrate W, when the substrate W is located at the single-wafer delivery position P2. A step 69 like stairs is provided in the side. A stopper fixture 90c is a member extending in the vertical direction (Z-direction), and a support member for arranging the stopper 90a and the stopper 90b at the single-wafer delivery position P2. When the substrate is brought to the single-wafer delivery position P2, an outer periphery of the substrate W is inserted into the steps 69 of the stopper 90a and the stopper 90b and the substrate W is supported. The stopper 90a and the stopper 90b correspond to the supporting portion in the present invention. The stopper 90a and the stopper 90b are preferably made of fluororesin and the like.

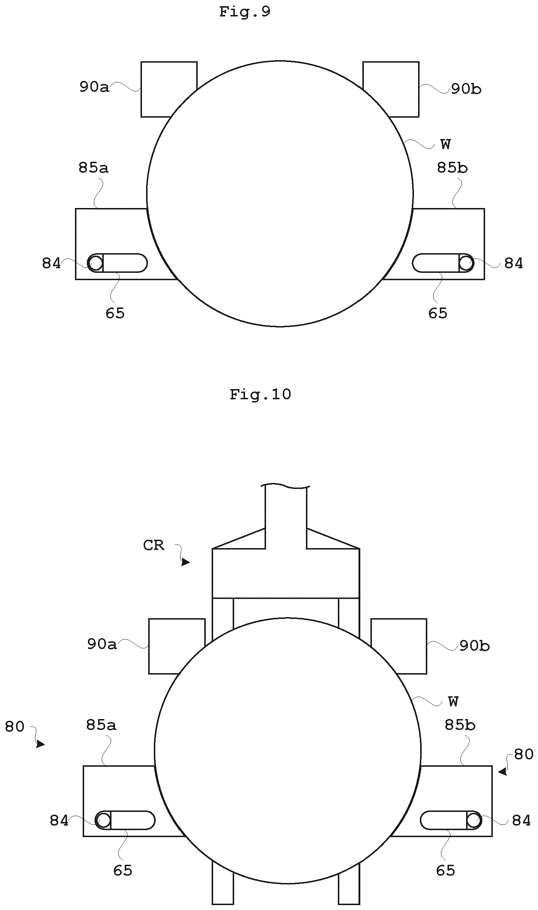

Fig. 9 illustrates a state where the stopper 90a and the stopper 90b help the first gripper 85a and the second gripper 85b to hold a substrate W. As illustrated in Fig. 4, the first gripper 85a and the second gripper 85b have a suitable shape for pulling out the substrates W in one direction. Such a manner leads to negative holding of the substrate W when the substrate W is delivered to the center robot CR of the single-wafer transport region R3, especially increasing possibility that the substrate W slide in a direction apart from the first gripper 85a and the second gripper 85b. Here in this embodiment, the stopper 90a and the stopper 90b are provided at the single-wafer delivery position P2 for preventing movement of the substrate W in the direction as described above. As is apparent from Fig. 9, the first gripper 85a holds a left lower end of the substrate W, whereas the second gripper 85b holds a right lower end of the substrate W. Moreover, the stopper 90a holds a left upper end of the substrate W, whereas the stopper 90b holds a right upper end of the substrate W. As described above, the first gripper 85a, the second gripper 85b, the stopper 90a, and the stopper 90b are arranged so as to surround the substrate W at the single-wafer delivery position P2 to hold the substrate W.

Fig. 10 illustrates a state where the center robot CR receives the substrate W from the substrate pick-up unit 80 at the single-wafer delivery position P2. At this time, the substrate transport arms of the center robot CR are inserted into a clearance between the stopper 90a and the stopper 90b. Then, tip ends of the substrate transport arms pass through the clearance between the stopper 90a and the stopper 90b, and protrude from the substrate W at the single-wafer delivery position P2.

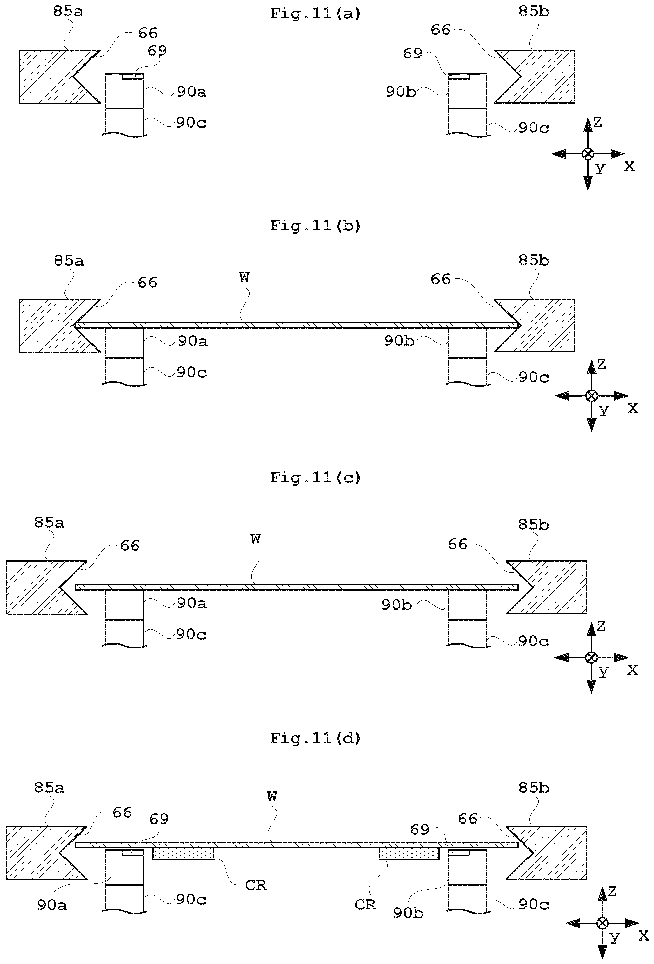

Fig. 11 is a sectional view illustrating in detail delivery of the substrate W at the single-wafer delivery position P2. Fig. 11(a) omits the substrate W for clarifying a positional relationship among the components. In this drawing, the stopper 90a and the stopper 90b each face toward the step 69. Accordingly, the substrate W is to be accommodated in front of the stopper 90a and the stopper 90b. In contrast to this, this drawing illustrates the first gripper 85a and the second gripper 85b in sectional view. It is understood from this drawing that the V-shaped groove 66 of the first gripper 85a faces the second gripper 85b and the V-shaped groove 66 of the second gripper 85b faces the first gripper 85a. The first gripper 85a and the second gripper 85b are positioned forward of the stopper 90a and the stopper 90b.

Fig. 11(b) is a drawing in which the substrate W to be gripped is added to Fig. 11(a). Fig. 11(b) illustrates the substrate W in sectional view, which is similar to the first gripper 85a and the second gripper 85b. The right and left ends of the substrate W are inserted into and rigidly held by the V-shaped grooves 66 of the first gripper 85a and the second gripper 85b. Positions of the steps 69 in the stopper 90a and the stopper 90b in the vertical direction (Z-direction) conform to deepest portions of the V-shaped grooves 66 in the first gripper 85a and the second gripper 85b, respectively. Accordingly, the substrate W is not bent even when it is held by the first gripper 85a, the second gripper 85b, the stopper 90a, and the stopper 90b.

Fig. 11(c) illustrates a state where the first gripper 85a and the second gripper 85b are slightly separated from each other from the state of Fig. 11(b), and the substrate W is ready to be delivered to the center robot CR. In this drawing, the first gripper 85a and the second gripper 85b do not hold the substrate W, leading to possibility that the substrate W slides out of the first gripper 85a and the second gripper 85b. However, the stopper 90a and the stopper 90b prevents such movement of the substrate W. The substrate W do not slide forward in Fig. 11(c). Such movement of the substrate W is avoided by the V-shaped grooves 66, curved along the substrate W, of the first gripper 85a and the second gripper 85b.

Fig. 11(d) illustrates a state where the substrate transport arms of the center robot CR are inserted below the substrate W from the state in Fig. 11(c). When the substrate transport arms move the substrate W slightly upward in the vertical direction, the substrate W is positioned above the steps 69 of the stopper 90a and the stopper 90b. Accordingly, the substrate transport arms can take the substrate W rearward regardless of presence of the stopper 90a and the stopper 90b. Since the first gripper 85a and the second gripper 85b are separated from each other as illustrated in Fig. 11(c), the substrate W is not held by the first gripper 85a and the second gripper 85b. Accordingly, the substrate transport arms can take the substrate W rearward regardless of presence of the stopper 90a and the stopper 90b.

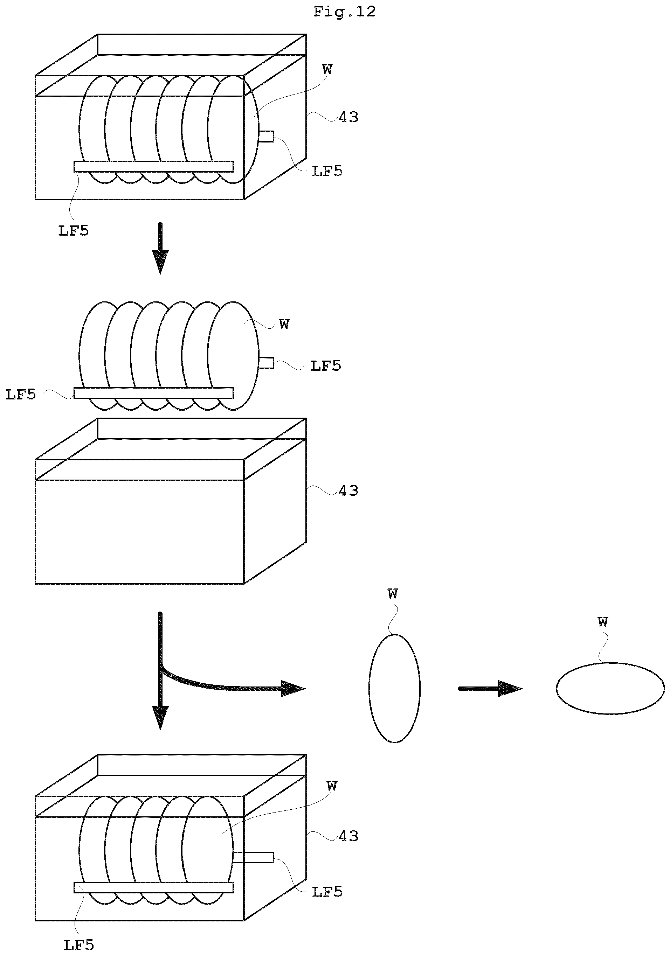

The following describes transport operation of the substrate W by the substrate pick-up unit 80. The apparatus in this embodiment can keep the substrates W, on which the batch treatment is already performed in the batch treatment region R1, at stand-by in liquid until the substrate W is delivered to the single-wafer treatment region R2. Fig. 12 schematically illustrates a state where the substrates W on which the batch treatment is performed are taken one by one from the lot held in liquid in the holding tank 43. For taking the substrates W one by one from the lot held in liquid, the lot is firstly moved upward above a liquid level of the holding tank 43 entirely. Such movement of the lot is performed by a lifter LF5 attached to the holding tank 43. The substrate pick-up unit 80 grips one of the substrates W, constituting the lot, that is positioned uppermost in the lot. When the substrate pick-up unit 80 finishes gipping the substrate W, the lifter LF5 moves downward, and the substrates W not gripped by the substrate pick-up unit 80 return into the liquid of the holding tank 43 collectively. In contrast to this, the substrate pick-up unit 80 turns a posture of the gripped substrate W from vertical to horizontal, and transports the substrate W to the single-wafer delivery position P2. As described above, the apparatus in this embodiment repeats upward movement of the lifter LF5, gripping of the substrate W, downward movement of the lifter LF5, posture turning of the substrate W, and transport of the substrate W, thereby transporting the substrates W, constituting the lot, one by one to the single-wafer treatment region R2. Such a configuration avoids drying of the substrates W, constituting the lot, while the lot is at standby for single-wafer treating.

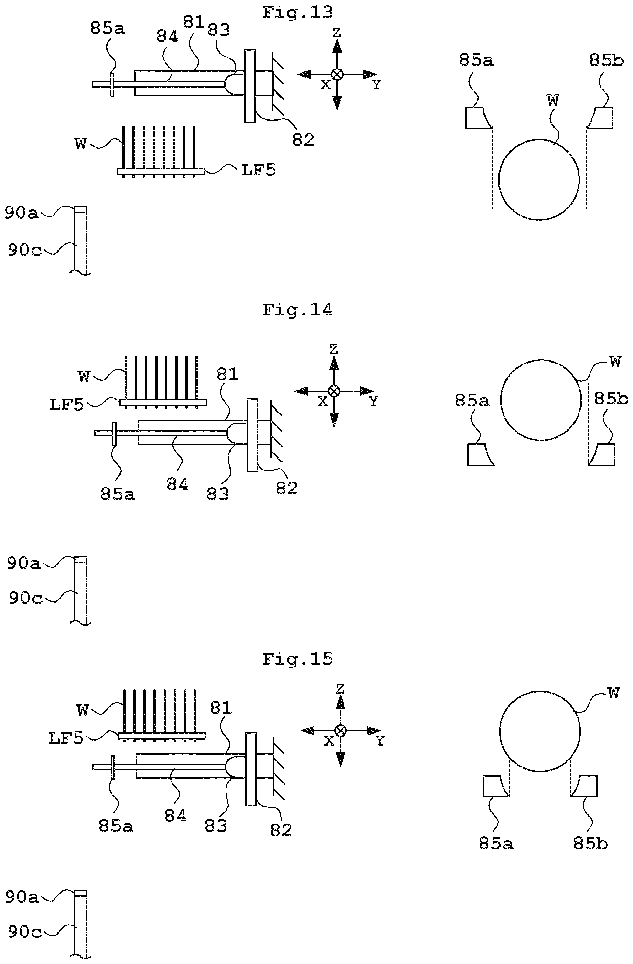

The following describes, with reference to Figs. 13 to 21, operation in detail where the substrate pick-up unit 80 picks up one substrate W from the substrates W in the liquid of the in-liquid holding unit 25 and transports the one substrate W to the single-wafer delivery position P2.

Fig. 13 illustrates an initial state before the substrate pick-up unit 80 grips the substrate W. Specifically, the rod 84 of the substrate pick-up unit 80 is in a posture extending in the transverse direction (Y-direction) and the support board 82 is moved to a proximal end of the linear guide 81. The first gripper 85a is positioned at a distal end of the rod 84. As shown in the right side in the drawing, the first gripper 85a and the second gripper 85b are separated from each other, and the substrate W can pass between the first gripper 85a and the second gripper 85b. The lifter LF5 in Fig. 13 keeps the lot moved upward to the substrate pick-up unit 80. In contrast to this, the lifter LF5 before the substrate pick-up unit 80 transports the substrate W is under a state before the lifter LF5 is moved upward, and the lot is immersed in the liquid of the holding tank 43.

Fig. 14 illustrates a state where the lifter LF5 moves upward to the above of the substrate pick-up unit 80. Since the first gripper 85a and the second gripper 85b of the substrate pick-up unit 80 are separated from each other, the substrate W placed on the lifter LF5 can pass between the first gripper 85a and the second gripper 85b without contacting the grippers as shown on the right side of this drawing.

Fig. 15 illustrates a state where the first gripper 85a approaches the second gripper 85b closer than the state in Fig. 14. At this time, a clearance between the first gripper 85a and the second gripper 85b is smaller than a diameter of the substrate W as shown on the right side of this drawing.

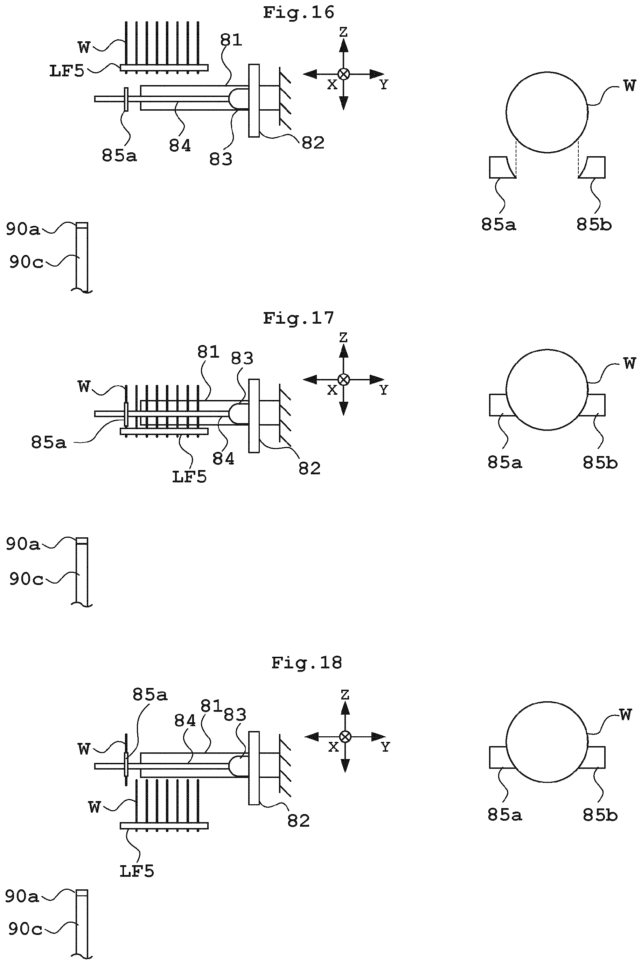

Fig. 16 illustrates a state where the first gripper 85a and the second gripper 85b move to the proximal end side of the rods 84 from the state as shown in Fig. 15. At this time, the first gripper 85a and the second gripper 85b are located at the same position in the transverse direction (Y-direction) as that of the substrate W (lead substrate W) of the substrates W, constituting the lot, that is nearest to the tip end of the linear guide 81. A clearance between the first gripper 85a and the second gripper 85b at this time is shown on the right side of this drawing, which is similar to Fig. 15 .

Fig. 17 illustrates a state where the lifter LF5 moves downward to the substrate pick-up unit 80 from the state in Fig. 16. At this time, since the first gripper 85a and the second gripper 85b approach each other, the first gripper 85a and the second gripper 85b hold the lead substrate W while contacting the periphery edge of the substrate W in the lot as shown in the right side of the drawing.

Fig. 18 illustrates a state where the lifter LF5 moves further downward from the state of Fig. 17. At this time, the lifter LF5 moves downward together with the substrates W not to be gripped except for the substrate W held by the first gripper 85a and the second gripper 85b. A state at this time of the substrate W held by the first gripper 85a and the second gripper 85b is shown on the right side of this drawing, which is similar to Fig. 17.

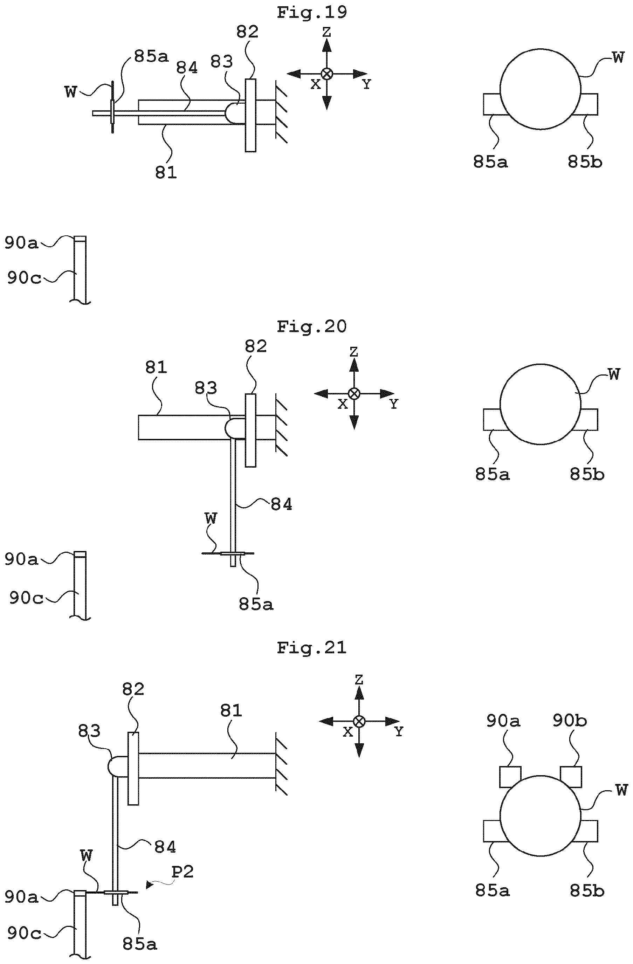

Fig. 19 illustrates a state where the lifter LF5 moves further downward from the state of Fig. 18. The lifter LF5 returns to the holding tank 43 and moves the substrates W, not to be gripped, under the liquid level of the holding tank 43. A state at this time of the substrate W held by the first gripper 85a and the second gripper 85b is shown on the right side of this drawing, which is similar to Fig. 17.

Fig. 20 illustrates a state where the rod 84 of the substrate pick-up unit 80 rotates by 90 degrees from the state of Fig. 19. Rotation of the rod 84 causes a posture of the substrate W gripped by the first gripper 85a and the second gripper 85b to be turned reversely to posture turn of the rod 84, i.e., from vertical to horizontal. A state at this time of the substrate W held by the first gripper 85a and the second gripper 85b is shown on the right side of this drawing, which is similar to Fig. 17. When a position of the substrate W in the vertical direction (Z-direction) does not conform to positions of the stopper 90a and the stopper 90b in the vertical direction (Z-direction), the first gripper 85a and the second gripper 85b move upward or downward to move the substrate W to a level same as those of the stopper 90a and the stopper 90b, respectively. Such movement of the first gripper 85a and the second gripper 85b relative to each of the rods 84 may be performed before the rods 84 rotate by 90 degrees (see Fig. 19).

Fig. 21 illustrates a state where the support board 82 is moved to the tip end of the linear guide 81 from the state of Fig. 20. At this time, the substrate W held by the first gripper 85a and the second gripper 85b approach the stopper 90a and the stopper 90b. Since the substrate W is positioned at the same level as that of the stopper 90a and the stopper 90b, the substrate W finally contacts the stopper 90a and the stopper 90b. In such a manner as above, the substrate W at stand-by in the liquid of the holding tank 43 is transported to the single-wafer delivery position P2. Then, as illustrated in the right side of this drawing, the first gripper 85a, the second gripper 85b, the stopper 90a and the stopper 90b hold the substrate W.

The substrate pick-up unit 80 repeats the operations of Figs. 13 to 21, thereby transporting the substrates W at stand-by in the in-liquid holding tank 43 one by one to the single-wafer delivery position P2.

### <5-2. Single-wafer treatment region>

The single-wafer treatment region R2 in the treating block 9 is a rectangular region adjoining the transferring block 7 in the front-back direction (X-direction). The region faces the in-liquid holding unit 25 in the batch treatment region R1 in the transverse direction (Y-direction). A single-wafer processing chamber CMB1 is provided in the single-wafer treatment region R2 for performing predetermined treatment on the substrates W one by one individually. The substrate treating apparatus 1 in this embodiment includes a single-wafer processing chamber CMB2 under the single-wafer processing chamber CMB1, and a single-wafer processing chamber CMB3 under the single-wafer processing chamber CMB2, and thus the three single-wafer processing chambers are stacked in a height direction (Z-direction). The single-wafer treatment region R2 may be formed by stacking single-wafer processing chambers having different functions. In this embodiment, the single-wafer processing chamber CMB2 and the single-wafer processing chamber CMB3 are configured in the same manner as that of the single-wafer processing chamber CMB1. In this embodiment, the three chambers are stacked to form the single-wafer treatment region R2. However, the number of chambers to be stacked may increase or decrease for the purpose of substrate treatment.

The single-wafer processing chamber CMB3 is a supercritical fluid chamber, for example. The supercritical fluid chamber performs dry treatment on the substrate W with carbon dioxide in form of supercritical fluid, for example. Fluid other than carbon dioxide may be used as the supercritical fluid for the dry treatment. The supercritical state is obtained by bringing carbon dioxide under critical temperature and pressure inherent in the fluid. Specifically, the pressure is 7.38 MPa and the temperature is 31 degrees Celsius. Under the supercritical state, the fluid has a surface tension of zero. Accordingly, circuit patterns on the front face of the substrate W are not affected by a gas-liquid interface. Consequently, the dry treatment on the substrate W with the supercritical fluid achieves prevention of collapse of the circuit patterns on the substrate W, i.e., pattern collapse.

### <5-3. Single-wafer transport region>

The single-wafer transport region R3 in the treating block 9 is a rectangular region adjacent to the transferring block 7. The single-wafer transport region R3 is arranged between the batch treatment region R1 and the single-wafer treatment region R2.

The single-wafer transport region R3 includes the center robot CR for transporting the substrates W in a horizontal posture. The center robot CR transports the substrates W from the single-wafer delivery position P2 in the batch treatment region R1 to any of the single-wafer processing chambers. The center robot CR includes a hand 29 that can take one substrate W in the horizontal posture at the single-wafer delivery position P2. The center robot CR can reciprocate in the vertical direction (Z-direction). In addition, the center robot CR can pivot in an XY-plane (horizontal plane). Accordingly, the hand 29 of the center robot CR rotates around a rotation axis extending in the Z-direction, allowing to face toward the batch treatment region R1 and the single-wafer treatment region R2. The center robot CR corresponds to the single-wafer substrate transport mechanism in the present invention.

The hand 29 of the center robot CR can advance and withdraw in the XY-plane (horizontal plane). Accordingly, the hand 29 can receive the substrates W at the single-wafer delivery position P2 of the batch treatment region R1, and can deliver the substrates W in the horizontal posture to each of the single-wafer processing chambers CMB1 to CMB3 in the single-wafer treatment region R2. The hand 29 of the center robot CR are provided with a plurality of tabs, with which the hand 29 can hold the substrates W rigidly.

### <5-4. Batch substrate transport region>

The batch substrate transport region R4 in the treating block 9 is a rectangular region extending in the front-back direction (X-direction). The batch substrate transport region R4 is provided along an outer edge of the batch treatment region R1, and a first end side thereof extends to the transferring block 7 and a second end side thereof extends so as to be apart from the transferring block 7.

The batch substrate transport region R4 is provided with the second transport mechanism WTR for transporting the substrates W collectively. The second transport mechanism WTR transports the substrates W (specifically, lot) collectively among the batch substrate delivery position P1 defined in the transferring block 7, the batch processing units BPU1 to BPU4, and the in-liquid holding unit 25. The second transport mechanism WTR is configured to reciprocate between the transferring block 7 and the treating block 9 in the front-back direction (X-direction). The second transport mechanism WTR is movable not only to the batch substrate transport region R4 in the treating block 9 but also to the batch substrate delivery position P1 in the transferring block 7. The second transport mechanism WTR corresponds to the batch substrate transport mechanism in the present invention. The second transport mechanism WTR is configured to transport the substrates W arranged at a half pitch collectively.

The second transport mechanism WTR includes one-paired batch hands 23 configured to transport a lot. The batch hands 23 include rotary shafts, respectively, that extend in the transverse direction (Y-direction), for example, and each swing around the rotary shaft. The one-paired batch hands 23 grasp both edges of the substrates W constituting the lot and arranged at the half pitch. The second transport mechanism WTR delivers the lot constituted by the substrates W, arranged at the half pitch, among the pusher 22A located at the batch substrate delivery position P1 in the transferring block 7, the lifters LF1 to LF4 in the batch processing units BPU1 to BPU4, respectively, and the lifter LF5 in the in-liquid holding unit 25.

In such a manner as above, the substrate treating apparatus 1 in this embodiment includes the elongated batch substrate transport region R4 extending in the front-back direction (X-direction), the elongated batch treatment region R1 extending in the front-back direction (X-direction), the single-wafer transport region R3 provided adjacent to the transferring block 7, and the single-wafer treatment region R2 provided adjacent to the transferring block 7 in this order from the left to the right.

The substrate treating apparatus 1 in this embodiment includes, in addition to the components described above, a central processing unit (CPU) 75 for controlling the mechanisms and the processing units, and a memory unit 76 for storing various types of information, such as programs and set values, needed in treatment processes. Here, a detailed construction of the CPU is not particularly limited. That is, one CPU may be provided in the whole apparatus, or one or more CPUs may be provided in each of the blocks. This is similarly applicable to the memory unit 76. The CPU controls, for example, the carrier transport mechanism 19, the first transport mechanism HTR, the second transport mechanism WTR, the posture turning unit 20, the pusher mechanism 22, and the mechanisms for the batch processing units BPU1 to BPU4, the in-liquid holding unit 25, the substrate pick-up unit 80, and the center robot CR.

### <Flow of substrate treatment>

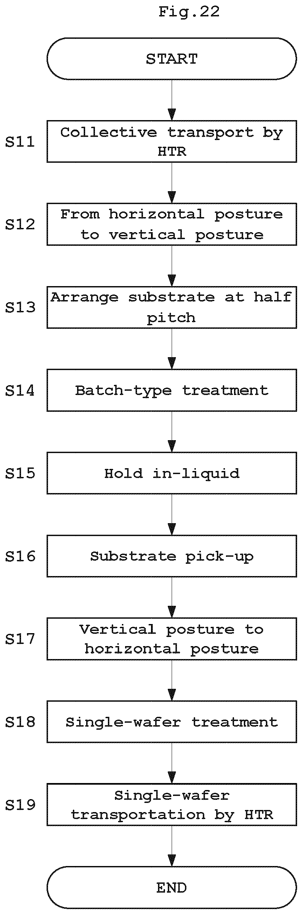

Fig. 22 is a flowchart illustrating a series of substrate treatment according to this embodiment. Here, the substrate treatment in this embodiment includes etching of front faces of substrates W and drying of substrates W during semiconductor device producing process. The following describes in detail a flow of the substrate treatment along with the flowchart.

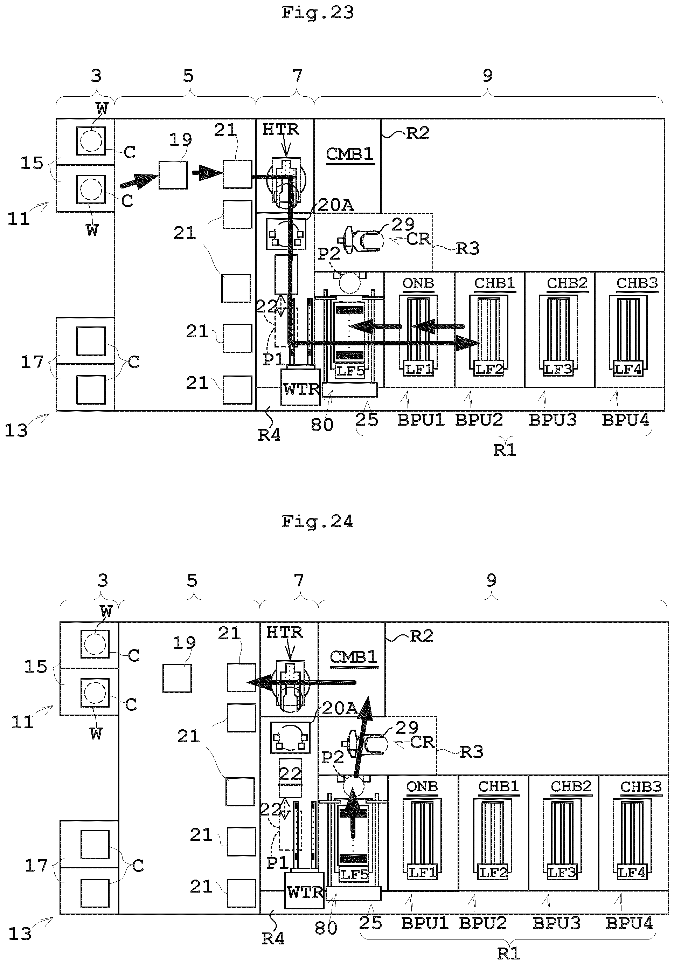

Step S11: A carrier C for accommodating untreated substrates W is placed on the mount table 15 of the loading unit 11. Thereafter, the carrier C is taken from the loading unit 11 into the apparatus, and placed on the delivery carrier mount shelf 21a provided in the stocker block 5 by the carrier transport mechanism 19 (see Fig. 23). The first transport mechanism HTR provided in the transferring block 7 takes a plurality of substrates W from the carrier C on the carrier mount shelf 21a collectively. Then, the first transport mechanism HTR delivers the substrates W in a horizontal posture to the posture turning unit 20 .

Step S12: The posture turning unit 20 turns the posture of the substrates W from horizontal to vertical to deliver the substrates W to the pusher mechanism 22. The pusher 22A of the pusher mechanism 22 has grooves, into which the substrates W are inserted, and empty grooves arranged alternately. The grooves are arranged at a half pitch, and thus the substrates W are arranged on the pusher 22A at a full pitch that is same as a pitch where the substrates W are accommodated in the carrier C.

Step S13: The pusher mechanism 22 receives another group of substrates, different from a group of the held substrates, from the posture turning unit 20 and performs processing such that substrates in the other substrate group are arranged at a half pitch. The next group of substrates to be delivered to the pusher 22A are inserted into the empty grooves in the step S12 individually. As described above, the pusher 22A has the grooves at a half pitch, into which the substrates W from a first carrier C and the substrate from a second carrier are arranged alternately. Since twenty-five substrates W are accommodated in one carrier C, the pusher 22A have two carriers of (fifty) substrates W arranged therein.

Step S14: Thereafter, batch-type treatment is performed on the substrates W. Specifically, the second transport mechanism WTR picks up the lot at a stand-by state at the batch substrate delivery position P1 collectively in the vertical direction (Z-direction), and then transports the lot in the front-back direction (X-direction). The substrates W in the vertical posture are delivered to any of the lifter LF2 to the lifter LF4 in the second batch processing unit BPU2 to the fourth batch processing unit BPU4, respectively, while the substrates W are arranged in the transverse direction (Y-direction). Here, the lifter LF2 to the lifter LF4 for receiving the substrates W are each at a delivery position. In such a manner as above, the lot is positioned above the liquid level of any of the batch chemical process tank CHB1 to the batch chemical process tank CHB3. Fig. 23 exemplarily illustrates a state where the lot is processed in the batch chemical process tank CHB1. The lifter LF2 having received the lot is moved downward to cause the lot to be immersed in chemical in the batch chemical process tank CHB1. Chemical treatment is performed on the lot in such a manner as above.

When the chemical treatment is completed, the lifter LF2 causes the lot to be exposed from the batch chemical process tank CHB1 over the liquid level. Thereafter, the second transport mechanism WTR picks up the lot collectively in the vertical direction (Z-direction), and then transports the lot in the front-back direction (X-direction). The substrates W in the vertical posture are delivered to the lifter LF1 of the first batch processing unit BPU1 while the substrates W are arranged in the transverse direction (Y-direction). At this time, the lifter LF1 is at a delivery position. In such a manner as above, the lot is positioned over the liquid level of the batch rinse process tank ONB. The lifter LF1 having received the lot is moved downward to cause the lot to be immersed in the batch rinse process tank ONB. Cleaning treatment is performed on the lot in such a manner as above (see Fig. 23).

When the cleaning treatment is completed, the lifter LF1 causes the lot to be exposed from the batch rinse process tank ONB over the liquid level. Thereafter, the second transport mechanism WTR picks up the lot in the vertical direction (Z-direction), and then transports the lot in the front-back direction (X-direction). The substrates W in the vertical posture are delivered to the in-liquid holding unit 25 while the substrates W are arranged in the transverse direction (Y-direction). See Fig. 10. At this time, the lifter LF5 of the in-liquid holding unit 25 is at a delivery position.

In the step S14 as described above, the second transport mechanism WTR collectively receives the substrates W in the vertical posture at the batch substrate delivery position P1 in the transferring block 7, and transports the received substrates W to the second batch processing unit BPU2 and the like for liquid treatment, the first batch processing unit BPU1 for rinse treatment, and the in-liquid holding unit 25 in this order.

Step S15: The lot delivered to the lifter LF5 of the in-liquid holding unit 25 is moved downward by the lifter LF5 to a standby position (corresponding to a processing position of the lifter LF1 of the first batch processing unit BPU1). The substrates W at the standby position are under the liquid level. This can prevent drying of the front faces of the substrates W.

Step S16: As shown in Fig. 24, the substrate pick-up unit 80 causes the lifter LF5 to receive one substrate W from the substrates W held in liquid in the in-liquid holding unit 25. A posture of the received substrate W is turned as mentioned later, and the substrate W is transported to the single-wafer delivery position P2. The lifter LF5 moves downward and causes a substrate to be transported in a diluted IPA solution of the holding tank 43 every time the substrate W is received. This never dries the substrates W naturally during this step.

Step S17: The substrate pick-up unit 80 turns a posture of the substrates W, pulled out of the holding tank 43 in the in-liquid holding unit 25, from vertical to horizontal. Thereafter, the substrate pick-up unit 80 transfers the substrates W in the horizontal posture horizontally to the single-wafer delivery position P2. The center robot CR in the single-wafer transport region R3 receives the substrates W at the single-wafer delivery position P2, and transports the substrates W to an inlet of the single-wafer processing chamber CMB1. Fig. 24 illustrates a state where the substrates W are transported to the single-wafer processing chamber CMB1 selected from the single-wafer processing chambers CMB1, CMB2, and CMB3.

Step S18: The substrates W transported into the single-wafer processing chamber CMB1 are subjected to single-wafer processing. Specifically, the substrates W are subjected to dry treatment, for example. The inlet and an outlet of the single-wafer processing chamber CMB1 are each closed by a shutter during the treatment.

Step S19: The substrates W subjected to the single-wafer processing return back to a carrier C by the first transport mechanism HTR. That is, when the single-wafer processing is completed, the shutter of the single-wafer processing chamber CMB1 is controlled for making the outlet of the single-wafer processing chamber CMB1 opened. The returning hand 71b of the first transport mechanism HTR enters the single-wafer processing chamber CMB1 from the outlet, picks up the substrates W in the single-wafer processing chamber CMB1, and retracts from the single-wafer processing chamber CMB1 while picking up the substrates W. The first transport mechanism HTR under such a condition returns one substrate W to the carrier C placed on the carrier mount shelf 21a.

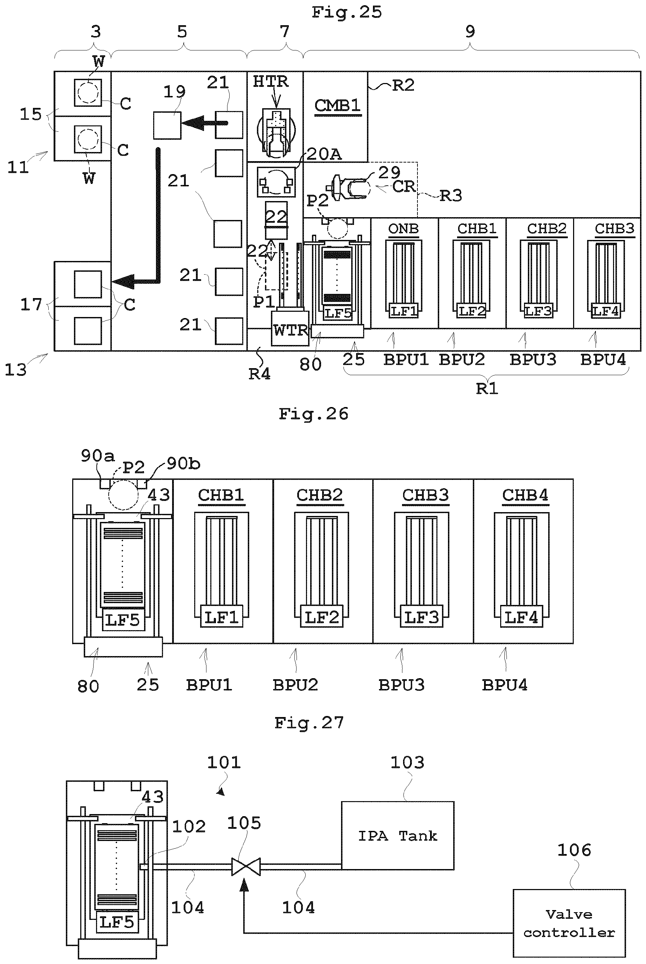

Description is made as above to the steps S16 to S19 while focusing one substrate W held in liquid, and the steps S16 to S19 are repeated until all the substrates W are returned from the in-liquid holding unit 25 to the carrier C. Finally, as shown in Fig. 25, the carrier C for accommodating the treated substrates W is moved from the carrier mount shelf 21a to the mount table 17 of the unloading unit 13. Such movement of the carrier C is performed by the carrier transport mechanism 19. This finishes the substrate treatment in the present invention.

As described above, the configuration according to this embodiment can further simplify the construction of the substrate treating apparatus 1 provided with the batch-type module and the single-wafer-type module. The apparatus in this embodiment includes the posture turning unit 20 configured to turn the horizontal posture of the substrates W aligned in the vertical direction collectively to the vertical posture, a plurality of batch chemical process tanks CHB configured to collectively perform liquid treatment to the substrates W whose posture is turned, and the holding tank 43 where the substrates W after the liquid treatment stand by. This embodiment needs no complex operation of taking out one substrate W of the substrates W at a stand-by state from the holding tank 43, turning the posture of the substrate W, and transporting the substrate W to the single-wafer transport region R3, but has the configuration where one substrate W is taken out from the holding tank 43 with use of the existing devices. That is, the apparatus in this embodiment is configured such that, with use of the lifter LF5 provided in the holding tank 43, one substrate W of the substrates W is delivered to the substrate pick-up unit 80 that is capable of turning the posture of the substrate W and transporting the substrate W. That is, the apparatus in this embodiment is configured such that the substrate pick-up unit 80 holds one substrate W of the substrates W held by the lifter LF5 when the lifter LF5 passes downward from the above. The substrate pick-up unit 80 also includes the rod rotating mechanism 61a for turning the posture of the substrate W and the support base moving mechanism (motor 62a, linear guide 81) for moving the substrate W in the horizontal posture. Accordingly, with the embodiment, the substrate pick-up unit 80 may be configured while omitting one of the three processes of taking the substrate W from the holding tank 43, turning the posture of the substrate W, and transporting the substrate W to the given position. This simplifies the construction of the substrate pick-up unit 80 and also reduces positional errors in movement of the substrate W. Such a configuration achieves the substrate treating apparatus 1 that transports substrates W reliably and has suppressed manufacturing cost.

The present invention is not limited to the embodiment described above, but may be modified as under.

### <First modification>

The single-wafer processing chamber CMB in this embodiment described above is formed by the supercritical fluid chamber. However, the present invention is not limited to this configuration. A smaller chamber may be configured as the single-wafer processing chamber CMB for drying the substrates W in a spin-drying system. In such a configuration leads to increase in number of chambers placed in the single-wafer treatment region R2, achieving provision of an apparatus with high throughput.

### <Second modification>

A single-wafer dry treatment chamber is provided in the single-wafer treatment region R2 in this embodiment described above. However, the present invention is not limited to this configuration. A chamber capable of performing water-repellent treatment on front faces of the substrates or a chamber capable of performing dry treatment and water-repellent treatment on the substrates W may be placed in the single-wafer treatment region R2. As above, the present invention permits modification of the configuration flexibly for the purpose of use of the apparatus.

### <Third modification>

In the embodiment described above, both the batch rinse process tank ONB and the in-liquid holding unit 25 are provided. However, the present invention is not limited to this configuration. As shown in Fig. 26, in-liquid holding unit 25 may have the function of the batch rinse process tank ONB. With such a configuration, there needs no provision of the batch rinse process tank ONB in addition to the in-liquid holding unit 25. Consequently, a larger number of batch chemical process tanks CHB may be provided than the number in the embodiment shown in Fig. 1. That is, in this modification, batch chemical treatment may be performed effectively with four batch chemical process tanks CHB. Examples of liquids that the in-liquid holding unit 25 holds include deionized water.

### <Fourth modification>

In addition to the construction of the third modification described above, a function of mixing the IPA may be added in the in-liquid holding unit 25. The in-liquid holding unit 25 in this modification receives the lot while holding deionized water. The substrates W constituting the lot on which the rinse treatment is performed with deionized water have enhanced dry resistance by the IPA supplied from a supplying unit in the in-liquid holding unit 25, and thus are transported to the single-wafer processing chamber CMB3 reliably without drying naturally while transported by the substrate pick-up unit 80 in the air. A supplying unit 101 in Fig. 27 is located in the batch treatment region R1 of the treating block 9. The supplying unit 101 includes a nozzle 102 for ejecting IPA to the holding tank 43, an IPA tank 103 for containing the IPA, a supplying pipe 104 between the IPA tank and the nozzle for passing the IPA therethrough, and a valve 105 inserted in the midstream of the supplying unit 103. The valve 105 is configured so as to supply the IPA to the holding tank 43 under an opened state or stop the supply under a closed state, which states are controlled by a CPU 75 (valve controller 106).

### <Fifth modification>

In the embodiment described above, a plurality of single-wafer processing chambers CMB stacked in the vertical direction are provided the single-wafer treatment region R2. However, the present invention is not limited to this configuration. One single-wafer processing chamber may be provided in the single-wafer treatment region R2.

### <Sixth modification>

In the embodiment described above, the stopper 90a and the stopper 90b are provided in the batch treatment region R1. However, the present invention is not limited to this configuration. The stopper 90a and the stopper 90b may be omitted as long as there is no risk that the substrate W in the horizontal posture gripped by the substrate pick-up unit 80 slides downward to the single-wafer transport region R3.

### <Seventh modification>

In the embodiment described above, the substrates W accommodated in one carrier C and the substrates W accommodated in another carrier C are batched to form a lot in which the substrates W are aligned at a half pitch. However, the present invention is not limited to this configuration. The present invention is also applicable to an apparatus not batching the substrates. With this apparatus, the transport mechanism WTR collectively transports twenty-five substrates W aligned at a full pitch, and the lifters LF1, LF2, LF3, LF4, and LF5 collectively receive the twenty-five substrates W, aligned at the full pitch, from the transport mechanism WTR.

### <Eighth modification>

In the embodiment described above, the taking hand 71a and the returning hand 71b are provided in the first transport mechanism HTR. However, the present invention is not limited to this configuration. In addition to the robot provided with the taking hand 71a, a robot provided with the returning hand 71b may be arranged in the transferring block 7 to form the substrate treating apparatus 1. Such a configuration achieves taking and returning of the substrates W at the same time, leading to provision of the substrate treating apparatus 1 having high throughput.

### <Ninth modification>

As shown in Figs. 20 and 21 in the embodiment described above, the substrate pick-up unit 80 can transport the substrates W in the horizontal posture in the transverse direction (Y-direction). However, the present invention is not limited to this configuration. The center robot CR may be configured so as to directly receive the substrates W whose posture is already turned (see Fig. 20), which corresponds to the configuration where the linear guide 81 of the substrate pick-up unit 80 is omitted. With this configuration, there is no need to provide the stopper 90a, the stopper 90b, and the stopper fixture 90c.

### <Tenth modification>

In the embodiment described above, the lifter LF5 is configured to move downward relative to the first gripper 85a and the second gripper 85b, thereby causing the first gripper 85a and the second gripper 85b to hold one substrate W on the lifter LF5. However, instead of such a configuration where the lifter LF5 moves downward, the first gripper 85a and the second gripper 85b may move upward relative to the lifter LF5. With such a configuration, the first gripper 85a and the second gripper 85b can be positioned below the lot immersed in the holding tank 43 while they are separated from each other, which is illustrated in Fig. 7. From this state, the first gripper 85a and the second gripper 85b approach each other as illustrated in Fig. 6, and can move more upward to the lifter LF5. With this modification, the substrate W is delivered from the lifter LF5 to the substrate pick-up unit 80 in liquid. Accordingly, as is described in the embodiment, there is no need to take out the lot from the liquid entirely every time the substrate W is transported to the single-wafer delivery position P2. Consequently, the substrate W to be transported can be at a stand-by state reliably.

### <Eleventh modification>

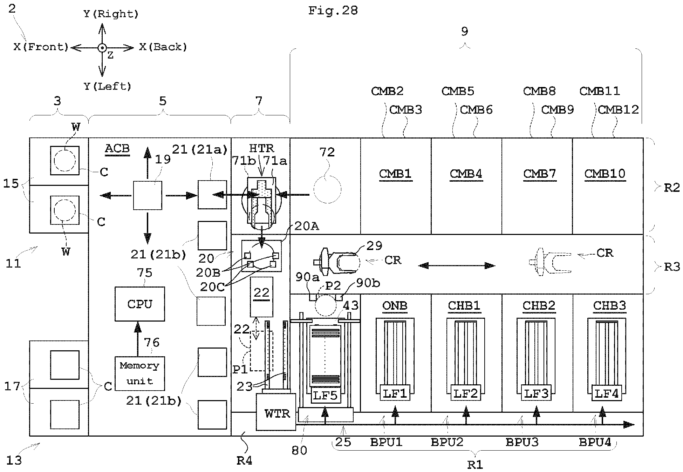

In the embodiment described above, single-wafer treatment region R2 is configured by stacking the single-wafer processing chambers CMB1 to CMB3 in the height direction. However, the present invention is not limited to this configuration. A larger number of single-wafer processing chambers may be provided in the single-wafer treatment region R2. As shown in Fig. 28, the single-wafer transport region R3 may be configured to extend in a direction so as to separate from the transferring block 7, and the center robot CR provided in the single-wafer transport region R3 may be configured to be movable in the front-back direction (X-direction). Accordingly, the single-wafer treatment region R2 can extend in the longitudinal direction (X-direction). In the single-wafer treatment region R2 in Fig. 28, four stack members each constituted by three single-wafer processing chambers are arranged in the front-back direction (X-direction). That is, the single-wafer processing chambers CMB1 to CMB3 form a first stack member, and single-wafer processing chambers CMB4 to CMB6 form a second stack member. Single-wafer processing chambers CMB7 to CMB9 form a third stack member, and single-wafer processing chambers CMB10 to CMB12 form a fourth stack member. The first stack member, the second stack member, the third stack member, and the fourth stack member are arranged in this order in a direction apart from the transferring block 7. Moreover, a single-wafer path 72 on which the substrates W in the horizontal posture can be placed is provided at a position between the first stack member and the transferring block 7. The substrates W subjected to the dry treatment in any of the single-wafer processing chambers CMB1 to CMB12 are transported by the center robot CR to the path 72 where the substrates W standby. Then, the returning hand 71b grips the substrates W, placed on the path 72, and returns the substrates W to the carrier C. With such a configuration to increase the number of single-wafer processing chambers, when single-wafer processing is performed to different substrates W simultaneously, the number of substrates W on which the processing is performed at the same time increases. This results in provision of a substrate treating apparatus 2 having high throughput.

### <Twelfth modification>

A position of the holding tank 43 in the batch treatment region R1 is not particularly limited in the configuration of the eleventh modification. As is described in Fig. 1, the holding tank 43 may be provided closer to the transferring block 7 than the batch chemical process tanks CHB1 to CHB3 and the batch rinse process tank ONB. Alternatively, the holding tank 43 may be provided farther to the transferring block 7 than the batch chemical process tanks CHB1 to CHB3 and the batch rinse process tank ONB. Moreover, the holding tank 43 may be incorporated into arrangement of the batch chemical process tanks CHB1 to CHB3 and the batch rinse process tank ONB. Here, the substrate pick-up unit 80 picks up the substrates W held in the holding tank 43. Accordingly, the substrate pick-up unit 80 is constantly positioned above the holding tank 43 regardless of the position of the holding tank 43.

### <Thirteenth modification>

In the embodiment described above, the first gripper 85a and the second gripper 85b separate from each other, thereby moving apart from the lifter LF5. The first gripper 85a and the second gripper 85b approach each other, thereby moving close to the lifter LF5. However, the present invention is not limited to this configuration. The first gripper 85a and the second gripper 85b may achieve a configuration to move apart from or close to the lifter LF5 even with the configuration where a distance between the first gripper 85a and the second gripper 85b is constant. Specifically, such a configuration may be adopted where the first gripper 85a and the second gripper 85b move apart from or close to the lifter LF5 by movement of the first gripper 85a and the second gripper 85b in the front-back direction (X-direction) while the distance between the first gripper 85a and the second gripper 85b is kept constant.

The present invention may be embodied in other specific forms without departing from the spirit or essential attributes thereof and, accordingly, reference should be made to the appended claims, rather than to the foregoing specification, as indicating the scope of the invention.

### Reference Signs List

- 5: stocker block
- 7: transferring block
- 9: treating block
- 20: posture turning unit (posture turning mechanism)
- 21a: carrier mount shelf
- 22: pusher mechanism (substrate holder)
- 43: holding tank
- 61a: rod rotating mechanism
- 62a: motor (support base moving mechanism)
- 63a: slide mechanism (gripper moving mechanism)
- 71a: taking hand (taking handling mechanism)
- 71b: returning hand (returning handling mechanism)
- 80: substrate pick-up unit
- 81: linear guide (support base moving mechanism)
- 82: support board (support base)
- 83: joint (rod rotating mechanism)
- 84: rod
- 85a: first gripper
- 85b: second gripper
- C: carrier
- CHB1: batch chemical process tank (batch process tank)
- CHB2: batch chemical process tank (batch process tank)
- CHB3: batch chemical process tank (batch process tank)
- CMB1: single-wafer processing chamber
- CMB2: single-wafer processing chamber
- CMB3: single-wafer processing chamber
- CR: center robot (single-wafer substrate transport mechanism)
- LF5: lifter
- ONB: batch rinse process tank (batch process tank)
- P1: batch substrate delivery position
- P2: single-wafer delivery position
- R1: batch treatment region
- R2: single-wafer treatment region
- R3: single-wafer transport region
- R4: batch substrate transport region
- W: substrate
- WTR: second transport mechanism (batch substrate transport mechanism)

## Claims

1. A substrate treating apparatus for successively performing batch treatment for processing a plurality of substrates collectively and single-wafer treatment for processing the substrates one by one, the substrate treating apparatus comprising:
a stocker block;
a transferring block adjoining the stocker block; and
a treating block adjoining the transferring block;
the stocker block including a substrate-taking and accommodating carrier mount shelf which has at least one carrier placed thereon for taking the substrates into and out of the carrier and which is configured to house the carrier in which the substrates are accommodated while the substrates are aligned in a horizontal posture at a predetermined pitch in a vertical direction,
the transferring block including:
a taking handling mechanism configured to take the substrates collectively from the carrier placed on the carrier mount shelf;
a posture turning mechanism configured to turn a posture of the taken substrates collectively between a horizontal posture and a vertical posture; and
a substrate holder configured to hold the substrates in the vertical posture collectively at a predetermined batch substrate delivery position, the treating block including:
a batch treatment region whose first end adjoins the transferring block and whose second end extends apart from the transferring block;
a single-wafer treatment region spaced apart from the batch treatment region in a direction orthogonal to an extension direction of the batch treatment region;
a single-wafer transport region between the batch treatment region and the single-wafer treatment region; and
a batch substrate transport region which is provided along the batch treatment region and whose first end extends to the transferring block and whose second end extends apart from the transferring block,
the batch treatment region containing a plurality of batch process tanks configured to perform immersion treatment on the substrates collectively in the extension direction of the batch treatment region,
and further containing:
a holding tank configured to hold the substrates, aligned in the vertical posture in a predetermined direction orthogonal to the extension direction, in liquid,
a lifter configured to move the substrates upward and downward relative to the holding tank, and
a substrate pick-up unit configured to pick up one substrate from the substrates in the vertical posture held by the holding tank and turn a posture of the substrate from vertical to horizontal,
the substrate pick-up unit including:
one-paired rods which are provided above the holding tank and extend along an alignment direction of the substrates in the vertical posture held by the holding tank;
a support base configured to support a base of the one-paired rods;
a first gripper which moves reciprocatively in the alignment direction of the substrates in the vertical posture while being guided by one of the one-paired rods;
a second gripper which moves reciprocatively in the alignment direction of the substrates in the vertical posture while being guided by the other of the one-paired rods;
a gripper moving mechanism configured to bring the first gripper and the second gripper into a stand-by state, and move the first gripper and the second gripper under the stand-by state horizontally and move relatively to the lifter in the vertical direction, thereby bringing the first gripper and the second gripper into a substrate-gripped state,
the gripper moving mechanism moving the first gripper and the second gripper to a position where the first gripper and the second gripper do not contact the substrate held by the lifter when the first gripper and the second gripper positioned below the substrate held by the lifter move relatively to the lifter in the vertical direction in the stand-by state,
the gripper moving mechanism moving the first gripper and the second gripper to a position where the first gripper and the second gripper contact the substrate held by the lifter when the first gripper and the second gripper positioned below the substrate held by the lifter move relatively to the lifter in the vertical direction, and causing the first gripper and the second gripper to hold one substrate of the substrates held by the lifter in the substrate-gripped state; and
a rod rotating mechanism configured to turn a posture of the substrate, held by the first gripper and the second gripper, from the vertical posture to the horizontal posture by rotating the one-paired rods to be along the vertical direction while the first gripper and the second gripper holds the one substrate in the vertical posture,
the single-wafer treatment region further containing at least one single-wafer processing chamber configured to process the substrates one by one individually,
the single-wafer transport region containing a single-wafer substrate transport mechanism configured to transport the substrates, received from the substrate pick-up unit, to the single-wafer processing chamber,
the batch substrate transport region containing a batch substrate transport mechanism configured to transport the substrates collectively among the batch substrate delivery position defined in the transferring block, the batch process tank, and the holding tank, and
the transferring block further including:
a returning handling mechanism provided between the single-wafer treatment region in the treating block and the carrier mount shelf in the stocker block and configured to transport the substrates in the horizontal posture from the single-wafer treatment region to the carrier mount shelf.

2. The substrate treating apparatus according to claim 1, wherein
the substrate pick-up unit further includes a support base moving mechanism which causes the support base to move reciprocatively in the alignment direction of the substrates in the vertical posture held by the holding tank and which transports the substrates in the horizontal posture held by the first gripper and the second gripper to the single-wafer delivery position defined in the treating block, and
the single-wafer substrate transport mechanism receives the substrates at the single-wafer delivery position.

3. The substrate treating apparatus according to claim 1, wherein
the substrate pick-up unit causes the first gripper and the second gripper to hold one substrate of the substrates held by the lifter by vertical movement of the lifter and downward movement of the lifter above the first gripper and the second gripper in the vertical direction.

4. The substrate treating apparatus according to claim 1, wherein
the gripper moving mechanism in the substrate pick-up unit brings the first gripper and the second gripper into the stand-by state by separating the first gripper and the second gripper apart from each other, and brings the first gripper and the second gripper into the substrate-gripped state by bringing the first gripper and the second gripper closer to each other.

5. The substrate treating apparatus according to claim 1, wherein
the taking handling mechanism in the transferring block is constituted by a robot, which also serves as the returning handling mechanism.

6. The substrate treating apparatus according to claim 1, wherein
the holding tank is provided closer to the transferring block than the batch process tank.

7. The substrate treating apparatus according to claim 1, wherein
the single-substrate processing region in the treating block has a plurality of single-wafer processing chambers arranged in the extension direction, and
the single-wafer transportation region in the treating block has a first end adjoining the transferring block and a second end extending in the extension direction.

8. The substrate treating apparatus according to claim 1, wherein
the batch treatment region in the treating block contains:
a batch process tank configured to store an acid liquid for performing acid treatment on the substrates; and
a batch process tank configured to store deionized water for performing rinse treatment on the substrates, and
the holding tank stores a liquid where isopropyl alcohol is mixed or deionized water.

9. The substrate treating apparatus according to claim 1, wherein
the single-wafer processing chamber performs dry treatment with supercritical fluid.

10. The substrate treating apparatus according to claim 1, wherein
a plurality of single-wafer processing chambers is provided in the vertical direction in the single-wafer treatment region.

11. The substrate treating apparatus according to claim 1, wherein
the treating block further includes a support portion configured to support the substrates, transported to the single-wafer delivery position, from a side adjacent to the single-wafer transport region.
